(19) **Europäisches Patentamt / European Patent Office / Office européen des brevets**

(11) **EP 4 391 064 B1**

(12) **FASCICULE DE BREVET EUROPEEN**

(45) Date de publication et mention
de la délivrance du brevet:
**11.06.2025 Bulletin 2025/24**

(21) Numéro de dépôt: **23217472.2**

(22) Date de dépôt: **18.12.2023**

(51) Classification Internationale des Brevets (IPC):
*H10H 20/01* (2025.01)   *H10H 29/14* (2025.01)
*H10H 20/817* (2025.01)   *H10H 20/825* (2025.01)
*H10H 20/831* (2025.01)   *H10H 20/833* (2025.01)
*H10H 20/854* (2025.01)   *H10H 20/818* (2025.01)
*H10H 20/84* (2025.01)

(52) Classification Coopérative des Brevets (CPC):
**H10H 20/817; H10H 20/01335; H10H 20/018;
H10H 20/825; H10H 20/8314; H10H 20/833;
H10H 20/854; H10H 29/142;** H10H 20/818;
H10H 20/84

(54) **PROCÉDÉ DE FABRICATION DE MICRO-LEDS ET STRUCTURE À MICRO-LEDS RÉSULTANTE**

VERFAHREN ZUR HERSTELLUNG VON MIKRO-LEDS UND RESULTIERENDE STRUKTUR MIT MIKRO-LEDS

METHOD FOR MANUFACTURING MICRO-LEDS AND RESULTING STRUCTURE WITH MICRO-LEDS

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.12.2022 FR 2214156**

(43) Date de publication de la demande:
**26.06.2024 Bulletin 2024/26**

(73) Titulaire: **Commissariat à l'Energie Atomique et aux Energies Alternatives**
**75015 Paris (FR)**

(72) Inventeurs:
• **ALTAZIN, Stéphane**
  **38054 Grenoble Cedex 09 (FR)**
• **DE MARTINO, Paolo**
  **38054 Grenoble Cedex 09 (FR)**
• **MICHIT, Nicolas**
  **38054 Grenoble Cedex 09 (FR)**
• **PERNEL, Carole**
  **38054 Grenoble Cedex 09 (FR)**
• **SIMON, Julia**
  **38054 Grenoble Cedex 09 (FR)**
• **LEVY, François**
  **38054 Grenoble Cedex 09 (FR)**
• **AVENTURIER, Bernard**
  **38054 Grenoble Cedex 09 (FR)**

(74) Mandataire: **Brevalex**
**Tour Trinity**
**1 B Place de la Défense**
**92400 Courbevoie (FR)**

(56) Documents cités:
WO-A1-2021/233917   GB-A- 2 592 017
US-A1- 2020 251 460

**Description**

**DOMAINE TECHNIQUE**

La présente invention se rapporte au domaine général des micro-écrans couleur. L'invention concerne un procédé pour fabriquer des micro-LEDs. L'invention concerne également une structure ainsi obtenue. L'invention est particulièrement intéressante car elle permet d'améliorer l'uniformité et la reproductibilité d'émission de micro-écran à base de micro LED, notamment des micro-LED de type GaN. L'invention trouve des applications dans de nombreux domaines industriels, et notamment dans le domaine des micro-écrans couleur à base de micro-LEDs.

**ÉTAT DE LA TECHNIQUE ANTÉRIEURE**

Les micro-écrans couleurs comprennent des pixels formés de sous-pixels bleus, verts et rouges (pixels RGB). Dans la suite de la description, ces sous-pixels seront désignés plus simplement pixel par souci de concision.

Les pixels bleus et verts peuvent être fabriqués à base de matériaux nitrures et les pixels rouges à base de matériaux phosphures. Des pixels rouges peuvent aussi être obtenus à base de matériaux nitrures, par exemple, par croissance sur un substrat comportant du GaN poreux.

Un micro-écran de diodes électroluminescentes (DEL ou LED pour *« light-emitting diode »*) à base de GaN comporte une matrice de micro LEDs unitaire sur un substrat comprenant un circuit CMOS. Une LED correspond à un pixel. Chaque LED est connectée au circuit CMOS.

Selon un procédé de fabrication classique, une épitaxie de GaN et une anode supérieure peuvent être pixellisées directement sur le substrat de croissance (en saphir ou en Si), une électrode (cathode) peut être déposée (avec ou sans contact avec le n-GaN), puis des plots métalliques ajoutés par les moyens de la micro-électronique pour permettre un report avec interconnexion du substrat contenant les pixels sur le circuit de commande CMOS. Le retrait du substrat de croissance et l'amincissement du GaN permet d'ajouter des fonctions électriques en face arrière (contact avec le n-GaN si non réalisés en face avant), ainsi que de limiter le cross talk entre pixels et d'ajouter des fonctions optiques du côté de l'émission lumineuse (par exemple dans les couches de passivation supérieures).

Un autre procédé pour fabriquer des micro-LEDs consiste à coller une épitaxie de GaN et une anode non pixellisées directement sur une plaque de silicium contenant le circuit CMOS. Le collage est un collage métallique permettant la conduction du courant électrique (collage eutectique ou direct). Puis, cet ensemble circuit CMOS et épitaxie de GaN est aminci afin de pouvoir utiliser, par la suite, les procédés de la micro-électronique traditionnels. L'épitaxie ainsi que la couche de collage sont ensuite pixellisées afin d'individualiser les micro-LEDs de la matrice de micro-écran. Chacune des micro-LEDs peut alors être adressée par le circuit CMOS.

Une électrode supérieure (cathode) permet le contact avec le n-GaN soit par contact latéral avec le n-GaN (par exemple en aluminium) soit par contact au-dessus de la couche de n-GaN avec une couche transparente conductrice, par exemple, en oxyde d'indium-étain (ou ITO pour *« indium tin oxide »*). L'indice optique de cette couche d'ITO est compris entre 1,9 et 2,1. Une couche d'encapsulation est ensuite déposée au-dessus du GaN. La couche d'encapsulation est, classiquement, réalisée à base de SiN dont l'indice optique est aussi compris entre 1,9 et 2,1.

L'indice optique du GaN est, quant à lui, d'environ 2,4.

Cependant, dans ces deux procédés de fabrication des matrices de micro LED, décrits précédemment, on introduit une variation de l'épaisseur (TTV : *« total thickness variation »*) du GaN, non seulement à l'échelle de la tranche (*« wafer »*) mais aussi de tranche à tranche. Ces variations d'épaisseurs proviennent à la fois des variations d'épaisseur de l'épitaxie mais surtout des procédés d'amincissement ou des procédés de planarisation utilisés afin d'enlever les couches tampons (*« buffer »*) de l'épitaxie épaisses de plusieurs microns, du fait des non uniformités des procédés utilisés. Or, ces variations d'épaisseur peuvent conduire à une variation des performances optiques de la LED (luminance, émission angulaire, spectre etc), en particulier lorsque l'anode est un miroir, et que la LED ainsi formée est de type cavité résonante (source émissive dans un résonateur Fabry-Pérot). Une modification de l'épaisseur du GaN modifiera la cavité optique formée entre l'anode, le GaN et l'interface optique supérieure (ITO/SiN dans l'exemple précédent), ce qui modifie l'extraction (dans le SiN dans l'exemple) et par conséquent l'extraction dans l'air.

Dans le cas où des dispositifs de type micro-lentille ou méta-surface sont structurés dans la couche d'encapsulation supérieure afin de maximiser l'extraction lumineuse et/ou afin de rediriger le flux optique dans une direction précise, l'uniformité de l'émission dans cette couche de passivation est d'autant plus importante. En effet, l'efficacité de ces dispositifs dépend de l'émission angulaire dans la couche de passivation.

Dans le cas où la couche d'encapsulation n'est pas structurée, l'uniformité de l'émission dans l'air (ou le contrôle de l'extraction dans l'air) peut être améliorée en introduisant une couche d'anti-reflet à l'interface couche de passivation/air ou en déposant une couche de passivation de forte épaisseur (typiquement environ ~1 µm).

L'ajout de l'anti-reflet sur la couche d'encapsulation évite un retour de la lumière dans l'empilement.

Cependant, même avec une couche d'anti-reflet, l'uniformité de l'émission dans l'air ne sera bonne que si l'émission dans la couche d'encapsulation est uniforme.

L'uniformité de l'émission dans le SiN peut être obtenue en élargissant le spectre d'émission de la LED (mais ce n'est pas ce qui est recherché pour ce type de dispositif) ou en épaississant le n-GaN mais cela a aussi tendance à diminuer l'EQE.

Cependant, ceci rajoute des étapes au procédé ou ne peut pas être compatible avec tous les dispositifs qui sont de plus en plus miniaturisés.

En effet, l'ajout de couches épaisses introduira des phénomènes d'interférence (« cross talk ») optique (aussi appelés diaphonie optique) entre pixels dans des dispositifs miniaturisés, par guidage latéral de la lumière dans les diélectriques.

En parallèle, des études de porosification du n-GaN sont menées. Il a, par exemple, été montré dans l'article de Lin et al. ('InGaN resonant microcavity with n+-porous-GaN/p+- GaN tunneling junction', IEEE Elec. Dev. Lett, vol. 42, No. 11, 2021) ou dans l'article de Mishkat-Ul-Masabih et al. ('Electrically injected nonpolar GaN-based VCSELs with lattice-matched nanoporous distributed Bragg Reflector mirrors', Appl. Phys. Express 12, 036504, 2019) qu'il est possible de fabriquer une LED à cavité résonante en positionnant des miroirs de Bragg à base de GaN poreux conducteurs en haut et en bas de la structure. La porosification permet de modifier l'indice optique du GaN et d'améliorer les propriétés électroluminescentes de la LED à cavité résonante, en particulier en obtenant des miroirs de Bragg à haute réflectivité de part et d'autre de la cavité optique, mais aussi un parfait contrôle de l'épaisseur de cavité optique ($1\lambda$ cavité par exemple).

Cependant, ce procédé est difficilement utilisable dans le cas de matrices de LEDs miniaturisées. L'épaisseur des miroirs de Bragg atteint plusieurs $\mu m$, ce qui pose un problème de facteur de forme pour les procédés d'intégration de la microélectronique. Ainsi les dispositifs décrits font plusieurs dizaines de micromètres de côté. De plus, l'empilement épitaxié est particulièrement complexe (car il contient une alternance de de couches fortement dopées et moins dopées), et induit une augmentation de la résistivité des $\mu$LEDs (le n-GaN poreux étant en général moins conducteur que le non poreux).

Les documents US 2020/0251460 A1, WO 2021/233917 A1 et GB 2 592 017 A divulguent diverses structures LEDs comprenant, ou pas, du GaN porosifié, ainsi que les procédés correspondants de fabrication.

## EXPOSÉ DE L'INVENTION

Un but de la présente invention est de proposer un procédé remédiant aux inconvénients de l'art antérieur, et permettant, notamment de fabriquer une micro-LED ayant une émission uniforme et répétable malgré les variations de procédé.

Pour cela, la présente invention propose un procédé de fabrication de micro-LED comprenant au moins les étapes suivantes :

i) fournir un empilement comprenant au moins une couche de GaN fortement dopé n, une couche de GaN dopé n, des puits quantiques et une couche de GaN dopé p et une première électrode,

ii) porosifier la couche de GaN fortement dopé n, moyennant quoi une couche de GaN porosifié est obtenue,

iii) former des mésas dans l'empilement,

iv) recouvrir la couche de GaN porosifié par une deuxième électrode formée d'une couche d'oxyde transparent conducteur, la deuxième électrode étant en contact direct avec la couche de GaN porosifié, puis, de préférence, recouvrir la deuxième électrode par une couche d'encapsulation,

ou

déposer une deuxième électrode sur une face latérale de la couche de GaN porosifié ou sur une face latérale de la couche de GaN dopé n et recouvrir la couche de GaN porosifié par une couche d'encapsulation, la couche d'encapsulation étant en contact direct avec la couche de GaN porosifié.

Les étapes ii) et iii) pouvant être réalisées dans l'ordre ii) et iii) ou dans l'ordre iii) et ii).

L'étape ii) est réalisée de manière à ce que l'indice optique de la couche de GaN porosifié ne varie pas de plus de 10% par rapport à l'indice optique de la deuxième électrode et/ou par rapport à l'indice optique de la couche d'encapsulation. De préférence, il ne varie pas de plus de 5% et encore plus préférentiellement il ne varie pas de plus de 2% par rapport à l'indice optique de la deuxième électrode et/ou de la couche d'encapsulation.

L'indice optique $n_{eff}$ de la couche de GaN porosifié dépend de la concentration volumique des pores dans la couche. Elle sera choisie en fonction des matériaux de la couche d'oxyde transparent conducteur et/ou de la couche d'encapsulation. La concentration volumique de pores peut être déterminée à partir de la formule approchée suivante :

$$n_{eff} = \sqrt{(1-p).n_{GaN}^2 + p.n_{air}^2}$$

avec p la concentration volumique de pores, $n_{GaN}$ l'indice optique du GaN non porosifié, et $n_{air}$ l'indice optique de l'air.

Par exemple, afin d'obtenir un indice effectif $n_{eff}$ de 1.9, une concentration de pores de l'ordre de 45% sera choisie.

Avantageusement, la couche d'oxyde transparent conducteur est une couche d'oxyde d'indium étain et/ou la couche d'encapsulation est en SiN, $SiO_2$ ou SiON. Avantageusement, la couche d'encapsulation a un indice optique proche de celui de l'ITO. De préférence, la couche d'encapsulation est en SiN.

L'invention se distingue fondamentalement de l'art antérieur par la présence d'une couche de GaN porosifié sous et en contact avec la couche d'oxyde transparent conducteur ou par la présence d'une couche de GaN porosifié sous et en contact avec la couche d'encapsulation.

L'indice optique du GaN est modifié par la porosification. La porosification est menée de telle sorte que l'indice optique de la couche de GaN porosifié soit proche de :

- l'indice optique des oxydes transparents conducteur (TCO), notamment de l'ITO, et/ou
- l'indice optique des couches d'encapsulation, par exemple en SiN, en particulier, dans le cas où l'électrode supérieure (par exemple en aluminium) recouvre les flancs de la couche porosifiée et où la couche porosifiée est en contact direct avec la couche d'encapsulation.

Comme les indices de la couche porosifiée, de la couche de TCO et de la couche d'encapsulation sont proches, les réflexions à ces interfaces sont minimisées, rendant l'émission dans le SiN indépendante des variations d'épaisseur du GaN poreux.

Avantageusement, la couche de GaN poreux présente une porosité entre 40% et 70% volumique pour avoir un indice optique effectif proche de 1.9 (i.e. proche de l'indice optique des couches supérieures) et ainsi minimiser les réflexions entre le GaN poreux et ces couches supérieures.

La couche de GaN poreux étant disposé entre l'anode (électrode inférieure) et la cathode (électrode supérieure, ici la couche d'oxyde transparent conducteur), la porosité ne sera pas trop élevée pour que cette couche porosifiée puisse transporter les électrons. Pour conserver une couche poreuse conductrice, il est possible de mettre en œuvre un dopage différentiel localisé de la couche n-GaN afin de conserver, à l'échelle du pixel, une zone non porosifiée.

La localisation fine de l'interface GaN/GaN poreux permet de contrôler l'épaisseur de la cavité de la LED et ainsi de positionner l'interface de réflexion entre le GaN et le GaN poreux à une position d'interférence constructive afin de maximiser l'extraction lumineuse. Il est possible de réduire ainsi les épaisseurs des micro-LEDs par le motif (*« design »*) de l'épitaxie, en compactant au maximum le stack p-GaN, puits quantiques et n-GaN à son minimum, avantageusement entre 250 et 500nm, afin de maximiser le couplage de la puissance optique dans le mode vertical plutôt que dans les modes guidés dans le plan. Les gains en extraction ainsi qu'en uniformité d'émission seront d'autant plus importants que l'épaisseur de GaN est faible.

Les couches de GaN sont, de préférence, formées par épitaxie.

La porosification est réalisée par anodisation électrochimique. La porosification électrochimique présente une sélectivité en fonction du niveau de dopage. Elle a lieu uniquement dans les zones les plus dopées n ($10^{19}$at.cm$^{-3}$ par exemple), définies notamment au cours de l'épitaxie. La position des zones poreuses est alors finement contrôlée. Ainsi, l'épaisseur de GaN non porosifié sera constante quelles que soient les variations d'épaisseur résultant du procédé. Les variations, introduites par le procédé de fabrication de la microLED, sont reportées dans la couche poreuse qui permet d'absorber les variations de process. La couche poreuse est une couche d'extraction optique tolérante aux variations d'épaisseur.

La pixellisation peut être faite avant ou après report, le substrat de croissance doit être retiré, du moins s'il est opaque (cas Si).

Avantageusement, l'épaisseur de la couche de GaN fortement dopé est comprise entre 100nm et 500nm, de préférence entre 200 et 500 nm. Ainsi, l'épaisseur de GaN est supérieure au TTV introduit par l'épitaxie et par les procédés d'amincissement (de l'ordre de 200nm).

Une couche anti-reflet peut être déposée sur la couche d'encapsulation.

Selon un premier mode de réalisation avantageux, le procédé est un procédé de réalisation micro-LED par collage monolithique de l'épitaxie.

Selon une variante de ce premier mode de réalisation, l'étape i) est, avantageusement, réalisée selon les étapes a) à c) suivantes :

a) fournir un empilement initial comprenant une couche support, éventuellement une couche tampon en (Al,Ga)N, une couche de GaN non intentionnellement dopé, la couche de GaN fortement dopé n, la couche de GaN dopé n, les puits quantiques, la couche de GaN dopé p et la première électrode,
b) reporter l'empilement initial sur un substrat support recouvert par une couche métallique,
c) retirer la couche support, le cas échéant la couche tampon en (Al,Ga)N, la couche de GaN non intentionnellement dopé, par exemple par amincissement, moyennant quoi on obtient un substrat d'intérêt comprenant le substrat support, la première électrode, la couche de GaN dopé p, les puits quantiques en GaN/InGaN, la couche de GaN dopé n et la couche de GaN fortement dopé n.

Selon une autre variante de ce premier mode de réalisation avantageux, le procédé peut comprendre, avant l'étape ii), une étape au cours de laquelle le taux de dopage de la couche de GaN fortement dopé n est localement diminué, par exemple par implantation d'ions hélium ou hydrogène, de manière à avoir une première partie de la couche de GaN fortement dopé n ayant une première conductivité et une deuxième partie de la couche de GaN fortement dopé ayant une deuxième conductivité, la première conductivité électrique étant supérieure d'au moins un facteur dix à la deuxième conductivité électrique, moyennant quoi :

- la deuxième partie n'est pas porosifiée lors de l'étape ii),
- la couche de GaN porosifié des mésas obtenues à l'étape iii) comprend une partie non porosifiée et une partie porosifiée, la partie non porosifiée étant de préférence au centre de la partie porosifiée.

Ainsi, la couche de GaN dopé comprend des zones dopées et des zones faiblement dopées, les zones faiblement dopées n'étant pas porosifiées lors de l'étape ii). La couche de GaN dopé des mésas obtenues à l'étape iii) comprend une partie centrale non porosifiée et un pourtour porosifié.

Toujours selon ce premier mode de réalisation avantageux, il est possible que le procédé comprenne les étapes suivantes :

- le procédé comprend une étape additionnelle entre l'étape i) et l'étape ii) au cours de laquelle la couche de GaN fortement dopé n et une partie de la couche de GaN dopé n sont gravées pour former une pré-structure de mésas,
- lors de l'étape ii), la partie centrale de la couche de GaN fortement dopé n n'est pas porosifiée, par exemple en arrêtant l'étape de porosification avant la porosification totale de la couche de GaN fortement dopé, moyennant quoi la couche de GaN des mésas obtenues à l'étape iii) comprend une partie centrale non porosifiée et un pourtour porosifié,
- l'étape iii) est réalisée en gravant l'autre partie de la couche de GaN dopé n, les puits quantiques, la couche de GaN dopé p, la première électrode et une partie du substrat support.

Dans ces deux variantes de réalisation, l'injection est améliorée car seule la périphérie de la couche de GaN est porosifiée. La zone non porosifiée au centre du pixel peut servir à reprendre le contact.

Selon un second mode de réalisation avantageux, le procédé est un procédé de réalisation micro-LED par retournement de puces (« *flip chip* ») ou collage hybride.

Selon ce second mode de réalisation, le procédé peut comprendre les étapes successives suivantes :

i) fournir un empilement comprenant une couche support, une couche de GaN non intentionnellement dopé, une couche de GaN fortement dopé n, une couche de GaN dopé n, des puits quantiques, une couche de GaN dopé p et une première électrode,

iii) former des mésas dans l'empilement, en gravant la première électrode, la couche de GaN dopé p, les puits quantiques, la couche de GaN dopé n, la couche de GaN fortement dopé n et une partie de la couche de GaN non intentionnellement dopé,

- mettre en œuvre l'étape ii) pour porosifier la couche de GaN fortement dopé n, moyennant quoi une couche de GaN porosifié est obtenue,
- reporter l'empilement obtenu sur un substrat support recouvert par une couche métallique,
- retirer la couche support, la couche de GaN non intentionnellement dopé, par exemple par amincissement, moyennant quoi on obtient un substrat d'intérêt comprenant le substrat support, la première électrode, la couche de GaN dopé p, les puits quantiques en GaN/InGaN, la couche de GaN dopé n et la couche de GaN fortement dopé n,
- mettre en œuvre l'étape iv).

Avantageusement, le procédé comprend en outre au moins l'une des étapes suivantes :

- déposer une couche anti-reflet est déposée sur la couche d'encapsulation,
- structurer la couche d'encapsulation par des micro-lentilles ou des méta-surfaces pour maximiser l'extraction lumineuse et/ou rediriger le flux optique dans une direction précise.

Le procédé peut, en outre, comprendre une étape de dépôt de diélectrique sur le flanc des mésas agissant comme couche de passivation des défauts créés lors de la gravure des mésas ainsi que le dépôt d'un élément électriquement et thermiquement conducteur, par exemple à base de cuivre, dans l'espace entre les mésas, créant ainsi la seconde électrode métallique (cathode) qui sera en contact avec le dépôt de contact N en ITO ou en utilisant le contact latéral.

Il est possible de réduire les épaisseurs des micro-LEDs, car les gains en extraction ainsi qu'en stabilité d'émission seront d'autant plus important que l'épaisseur de GaN est faible.

L'invention concerne également une structure de micro-LEDs obtenue selon le procédé décrit précédemment.

La structure de micro-LEDs comprend un empilement, l'empilement comprenant au moins une couche de GaN fortement dopé n et porosifié, une couche de GaN dopé n, des puits quantiques, une couche de GaN dopé p et une première électrode, des mésas étant formées dans l'empilement,

la couche de GaN porosifié étant recouverte et en contact direct avec une deuxième électrode formée d'une couche d'oxyde transparent conducteur, la deuxième électrode étant de préférence recouverte par une couche d'encapsulation,
ou
une deuxième électrode étant disposée sur une face latérale de la couche de GaN porosifié ou sur une face latérale de la couche de GaN dopé n, la couche de GaN porosifié étant recouverte et en contact direct avec une couche d'encapsulation,

dans tous les cas, l'indice optique de la couche de GaN porosifié ne variant pas de plus de 10% par rapport à l'indice optique de la deuxième électrode et/ou par rapport à l'indice optique de la couche d'encapsulation.

Par exemple, la structure comprend un substrat d'intérêt, le substrat d'intérêt comprenant un substrat support, une première électrode, une couche de GaN dopé p, des puits quantiques GaN/InGaN, une couche de GaN dopé n, une couche de GaN fortement dopé, des mésas étant formées dans le substrat d'intérêt. Les mésas comprenant la couche de GaN fortement dopé porosifiée, la couche de GaN dopé, les puits quantiques, la couche de GaN dopé p, l'électrode inférieure et une partie du substrat support. Les mésas sont recouvertes par une deuxième électrode formée d'une couche d'oxyde transparent conducteur, de préférence une couche d'oxyde d'indium étain, et/ou par une couche d'encapsulation.

Avantageusement, la couche de GaN fortement dopé des mésas comprend une partie centrale non porosifiée et un pourtour porosifié.

Selon une première variante de réalisation avantageuse, la partie centrale est faiblement dopée.

Selon une deuxième variante de réalisation avantageuse, la partie centrale est fortement dopée.

Avantageusement, la couche de GaN porosifié a une épaisseur comprise entre 100 et 500 nm, de préférence entre 300 et 500 nm.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

Les figures 1A à 1F représentent, de manière schématique, différentes étapes d'un procédé de fabrication de micro-LEDs selon un mode de réalisation particulier de l'invention ;

Les figures 2A à 2G représentent, de manière schématique, différentes étapes d'un procédé de fabrication de micro-LEDs selon un autre mode de réalisation particulier de l'invention ;

Les figures 3A à 3G représentent, de manière schématique, différentes étapes d'un procédé de fabrication de micro-LEDs selon un autre mode de réalisation particulier de l'invention ;

Les figures 4A à 4J représentent, de manière schématique, différentes étapes d'un procédé de fabrication de micro-LEDs selon un autre mode de réalisation particulier de l'invention ;

La figure 5A représente de manière schématique et en coupe, une structure de micro-LED, selon un exemple comparatif;

La figure 5B est un graphique représentant la luminance de la structure de la figure 5A en fonction de l'épaisseur de la couche de GaN ;

La figure 6A représente de manière schématique et en coupe une structure de micro-LED, selon un mode de réalisation particulier de l'invention ;

La figure 6B est un graphique représentant la luminance de la structure de la figure 6A en fonction de l'épaisseur de la couche de GaN poreux ;

La figure 7A représente de manière schématique et en coupe une structure de micro-LED, selon un autre exemple comparatif ;

La figure 7B est un graphique représentant la luminance de la structure de la figure 7A en fonction de l'épaisseur de la couche de GaN ;

La figure 8A représente de manière schématique et en coupe une structure de micro-LED, selon un autre mode de réalisation particulier de l'invention ;

La figure 8B est un graphique représentant la luminance de la structure de la figure 8A en fonction de l'épaisseur de la couche de GaN poreux ;

La figure 9 est un graphique représentant la luminance en fonction de l'angle d'émission, selon un mode de réalisation particulier de l'invention ;

La figure 10 est un graphique représentant l'EQE en fonction de l'épaisseur totale de GaN.

## EXPOSÉ DÉTAILLÉ DE MODES DE RÉALISATION PARTICULIERS

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », « dessous », etc. d'une structure s'appliquent en considérant que la structure est orientée de la façon illustrée sur les figures.

Bien que cela ne soit aucunement limitatif, l'invention trouve particulièrement des applications dans le domaine des micro-écrans monochromes ou des micro-écrans couleurs, et plus particulièrement pour la fabrication de LED. Cependant, elle pourrait être utilisée dans le domaine du photovoltaïque ou encore de l'électrolyse de l'eau (« *water splitting* ») puisque, d'une part, l'InGaN absorbe dans tout le spectre visible et que, d'autre part, ses bandes de valence et de conduction sont autour du domaine de stabilité de l'eau, condition thermodynamique nécessaire à la réaction de décomposition de l'eau. L'invention peut également être intéressante pour la fabrication de laser émettant à grande longueur d'onde.

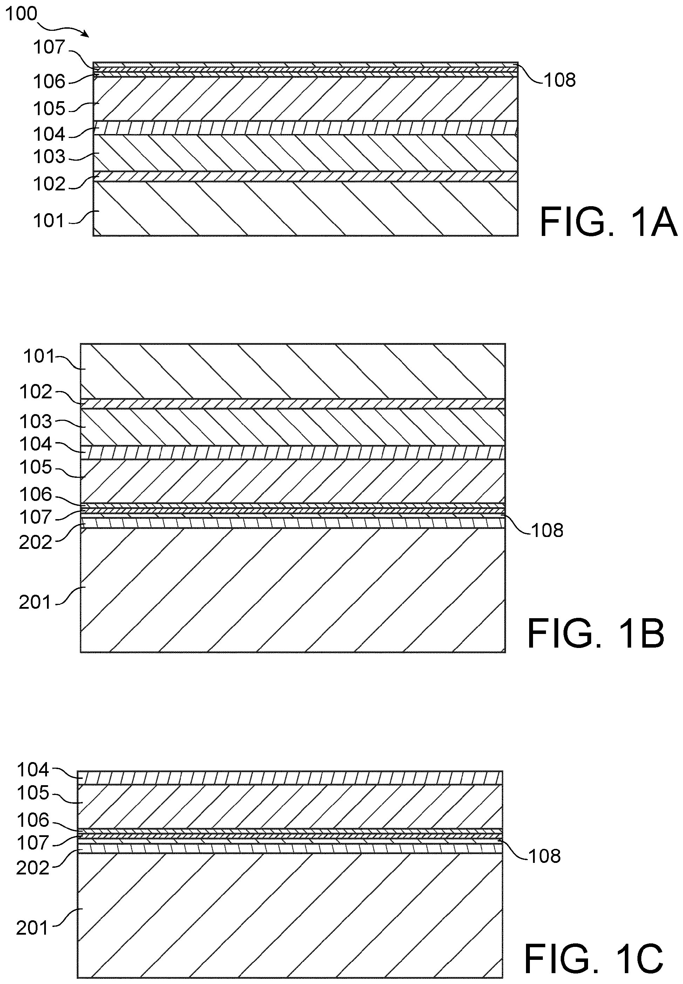

L'invention est plus particulièrement décrite pour une intégration de type monolithique par report complet des couches, c'est-à-dire que l'étape de porosification est réalisée après report (figures 1A à 1F, 2A à 2G et 3A à 3G).

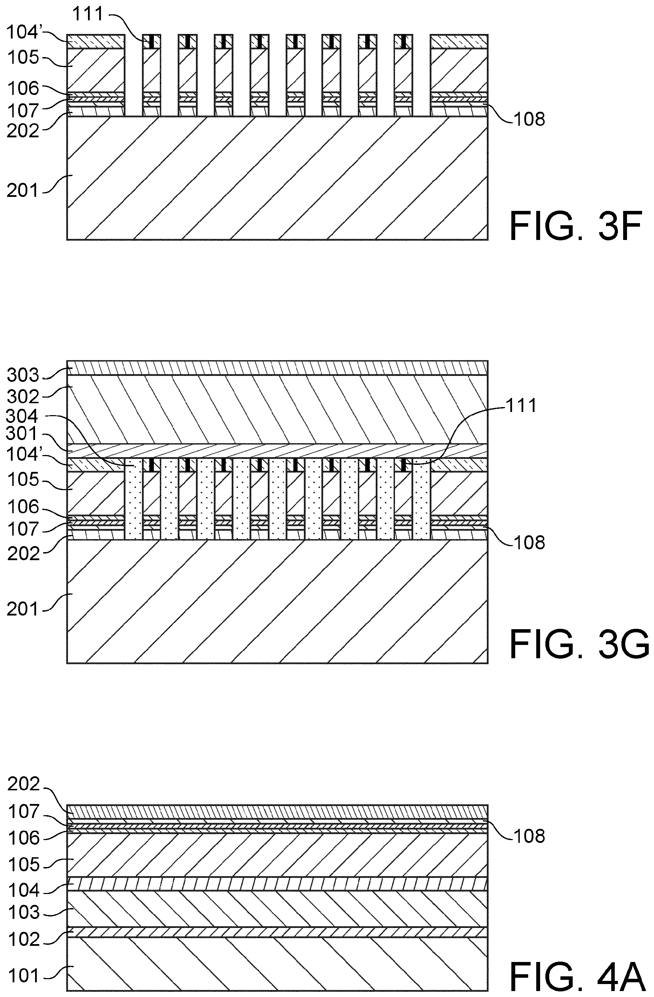

Cependant, il est également possible de réaliser l'étape de porosification sur le substrat de croissance, de fabriquer la LED puis de faire un assemblage de type puce retournée (« *flip chip* ») ou collage hybride sur un substrat comprenant un circuit intégré de type « ASIC » (« *Application-Specific Integrated Circuit* »). L'étape de porosification est réalisée avant report, ce qui permet d'avoir une relaxation pendant la croissance (figures 4A à 4J).

Le procédé est particulièrement intéressant pour fabriquer des structures comprenant des mésas (Al,In,Ga)N/(Al,In,Ga)N porosifiées ayant, notamment, un pas inférieur à 30 $\mu$m.

Par (Al,In,Ga)N, on entend AlN, AlGaN, InGaN ou GaN. Par la suite, on fait plus particulièrement référence à du GaN poreux, mais il est possible d'avoir, par exemple, de l'InGaN ou du AlGaN poreux.

Nous allons décrire plus en détail le procédé de fabrication de micro-LED en faisant référence aux figures 1A-1F, 2A-2G et 3A-3G annexées.

Le procédé de fabrication de micro-LED comprend les étapes suivantes :

a) fournir un premier empilement 100 comprenant (figures 1A, 2A, 3A) :

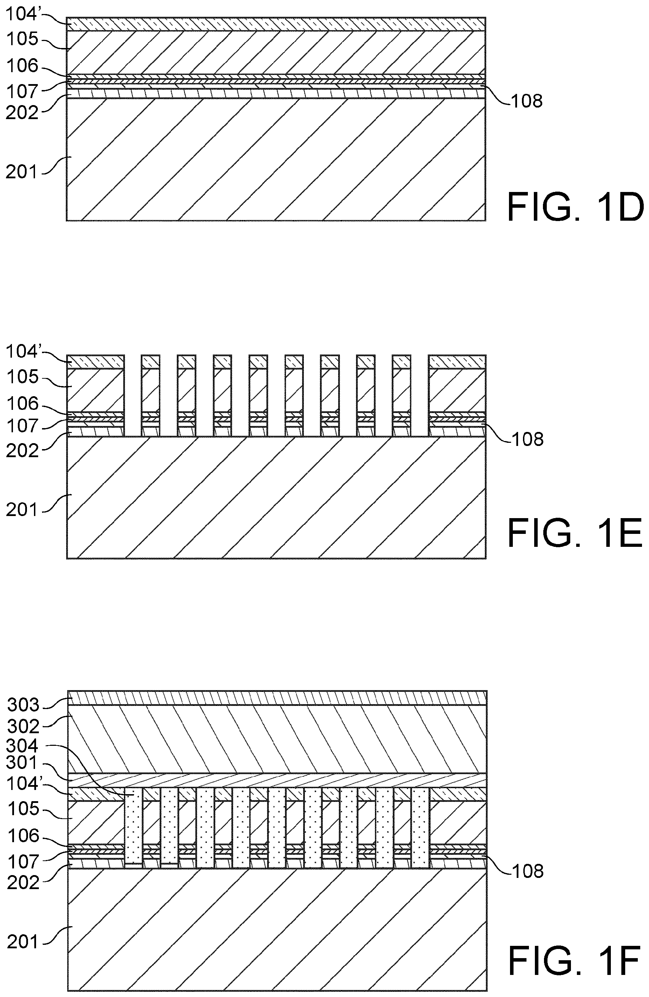

- un substrat de base 101,
- éventuellement une couche tampon 102, par exemple en AlGaN,
- une couche 103 en GaN non intentionnellement dopé (nid GaN),
- une couche 104 de GaN fortement dopé n (n⁺-GaN), ayant une première conductivité électrique,
- une couche 105 de GaN dopé n (n-GaN),
- des puits quantiques 106 en Gan/InGaN,
- une couche 107 de GaN dopé p (p-GaN),
- une première électrode 108 (ou électrode inférieure), de préférence métallique,

b) reporter le premier empilement 100 sur un substrat support 201, recouvert par une couche électriquement conductrice 202, de préférence une couche métallique (figures 1B, 2B, 3B), la couche métallique 202 s'interconnectant avec la première électrode 108 lors du report, de préférence réalisé par collage métal-métal,

c) retirer le substrat de base 101, puis retirer la couche tampon 102 le cas échéant et la couche 103 en GaN nid, par exemple par amincissement, moyennant quoi on obtient un substrat d'intérêt comprenant le substrat support 201, l'électrode inférieure 202, la couche 107 de GaN dopé p, les puits quantiques 106 en GaN/InGaN, la couche 105 de GaN dopé n, la couche 104 de GaN fortement dopé n (figures 1C, 2C, 3C),

d) porosifier partiellement ou totalement la couche 104 de GaN fortement dopé n, moyennant quoi on obtient une couche 104' de GaN porosifié (figures 1D, 2E, 3E),

e) former des mésas dans le substrat d'intérêt, les mésas comprenant la couche 104' de GaN porosifié, la couche 105 de GaN dopé, les puits quantiques 106, la couche 107 de GaN dopé p, l'électrode inférieure 108 et une partie du substrat support 201 (figures 1E, 2F, 3F).

Selon une première alternative, le procédé peut en outre comprendre les étapes suivantes :

f) recouvrir les mésas (i.e. recouvrir la face supérieure de la couche porosifiée 104') par une deuxième électrode 301 (ou électrode supérieure) formée par exemple d'une couche d'oxyde transparent conducteur, de préférence une couche d'oxyde d'indium étain (figures 1F, 2G, 3G),
g) éventuellement, déposer une couche d'encapsulation 302 sur la deuxième électrode 301,
h) éventuellement, déposer une couche anti-reflet 303 sur la couche d'encapsulation 302.

Selon une autre alternative, le procédé peut en outre comprendre les étapes suivantes :

f') former une deuxième électrode 301 (ou électrode supérieure) par exemple une couche d'oxyde transparent conducteur, ou une couche d'aluminium sur une face latérale des mésas (i.e. sur une face latérale de la couche porosifiée 104' et/ou sur une face latérale de la couche 105),

g') recouvrir les mésas (i.e. recouvrir la face supérieure de la couche porosifiée 104') par une couche d'encapsulation 302,

h') éventuellement, déposer une couche anti-reflet 303 sur la couche d'encapsulation 302.

Ainsi, le contact de la deuxième électrode 301 peut se faire sur la face supérieure de la couche 104' de GaN porosifé, sur la face latérale de la couche 104' de GaN porosifié ou sur la face latérale de la couche 105 de GaN dopé.

La face supérieure de la couche 104' de GaN porosifié est en contact direct avec l'électrode supérieure 301 en oxyde transparent conducteur ou en contact direct avec la couche d'encapsulation 302. Par en contact direct, on entend qu'il n'y a pas de couche intermédiaire entre les couches précitées.

Le premier empilement fourni à l'étape a) comprend un substrat de base 101 ayant, par exemple, une épaisseur allant de $250\mu m$ à 2mm. L'épaisseur dépend de la nature du substrat de base 101 et de ses dimensions. Par exemple, pour un substrat de base en saphir de 2 pouces de diamètre, l'épaisseur peut être de $350\ \mu m$. Pour une couche support en saphir de 6 pouces de diamètre, l'épaisseur peut être de 1,3mm. Pour une couche support en silicium de 200mm de diamètre, l'épaisseur peut être 1mm.

Dans le cas d'un substrat de base 101 en silicium, une couche tampon ('buffer') en (Al,Ga)N est, avantageusement, interposée entre le substrat 101 et la couche 103 de nid-GaN. Il s'agit d'une couche tampon pour la croissance.

La couche 103 de nid-GaN est une couche non intentionnellement dopée (nid) pour ne pas être porosifiée. Par GaN non intentionnellement dopé, on entend une concentration inférieure à $5\times10^{17}at/cm^3$. La couche 103 en GaN nid a, par exemple, une épaisseur allant de 500nm à $5\mu m$. Avantageusement, son épaisseur est entre 1 et 4 $\mu m$ pour absorber les contraintes liées au désaccord de maille entre le GaN et les couches sous-jacentes.

La couche 104 de GaN fortement dopé n est déposée sur la couche de GaN nid. Par GaN fortement dopé, on entend une concentration supérieure à $6\times10^{18}$ at/cm³, de préférence d'au-moins $8\times10^{18}$ at/cm³, voire supérieure à $10^{19}$ at/cm³. Elle a une épaisseur comprise entre 100nm et 500 nm, de préférence entre 200nm et 500 nm et encore plus préférentiellement entre 300nm et 500 nm. Cette couche permet d'absorber les TTV dues au procédé de fabrication des micro-LEDs. Cette couche est porosifiée lors de l'étape d).

La couche 104 de GaN fortement dopé n comprend deux faces principales (une face supérieure et une face inférieure) parallèles ou sensiblement parallèles entre elles et une face latérale.

La couche 105 de GaN dopé est formée sur la couche 104 de GaN fortement dopé. Par GaN dopé, on entend une concentration supérieure à $10^{18}$ at/cm³, de préférence entre $1\times10^{18}$ at/cm³ et $5\times10^{18}$ at/cm³. La couche en GaN a, par exemple, une épaisseur allant de 100nm à $1\mu m$. Elle doit être suffisamment électriquement conductrice pour pouvoir réaliser une reprise de contact sur cette couche lors de l'étape d'anodisation électrochimique. Cette couche électriquement conductrice est électriquement connectée au générateur de tension ou de courant. Avantageusement, elle assure la qualité du matériau de la couche supérieure. L'épaisseur minimale varie en fonction du taux de dopage.

La couche 105 de GaN dopé n comprend deux faces principales (une face supérieure et une face inférieure) parallèles ou sensiblement parallèles entre elles et une face latérale.

Par la suite, on décrit un dopage de type n, mais il pourrait s'agir d'un dopage de type p. Les dopages pourraient être inversés.

Les puits quantiques 106 sont, par exemple, des puits GaN/InGaN.

La couche 107 dopée p a, par exemple, une épaisseur comprise entre 100nm et 200nm Elle a, par exemple, un taux de dopage de $1\times10^{19}$.cm⁻³ voire d'au moins $1\times10^{20}$.cm⁻³ dans le cas d'un dopage Mg.

Les différentes couches de GaN précitées ainsi que les puits quantiques 106 sont formés par épitaxie.

Le premier empilement 100 peut être un empilement plus complexe et peut contenir, par exemple, un ou plusieurs des éléments suivants : une couche de blocage d'électrons AlGaN (ou EBL pour « Electron Blocking Layer »), un multicouche avec différents dopages pour réaliser des mésas poreux, etc.

Lors de l'étape b), le premier empilement (côté p) est reporté sur un deuxième empilement comprenant un substrat support 201 et une électrode inférieure 202 (ou première électrode). La première électrode 108 est déposée sur le premier empilement puis l'ensemble est reporté sur le substrat support 201 recouvert par la couche métallique 202.

Le substrat support 201 est, de préférence, un substrat comprenant un circuit intégré de type ASIC, (« *Application-Specific Integrated Circuit* »). Le circuit ASIC peut comprendre des composants électroniques (transistor(s), condensateur(s), résistances, etc.) permettant la commande/alimentation individuelle de chaque micro-LED en fonction de la couleur attendue pour le pixel. Les composants électroniques sont réalisés directement dans le volume (ou « *bulk* ») du substrat.

Le substrat support 201 peut être également un substrat matriciel de transistors en couches minces (TFT), notamment pour obtenir des écrans plus grands à vision directe.

Le substrat 201 est de préférence une tranche de silicium (ou « wafer »).

L'électrode inférieure 202 (ou première électrode) recouvre le substrat support. Elle pourrait également être en ITO. L'électrode inférieure 202 est par

Lors de l'étape c), le substrat de base 101, la couche tampon 102 le cas échéant, et la couche nid GaN 103 sont retirés. Par exemple, le substrat de base 101 est retiré par laser (aussi appelée technique de décollement ou « *lift off* »). La couche tampon 102 et la couche 103 en nid-GaN peuvent être retirées par amincissement. L'amincissement peut se terminer à l'interface couche 103 nid/couche 104 de GaN fortement dopé. De préférence, l'amincissement se termine dans la couche 104 de GaN fortement dopé.

Lors de l'étape d), on porosifie partiellement ou totalement la couche 104 de GaN fortement dopé. Plus le taux de dopage est élevé, et plus la porosification sera importante à potentiel fixe. Le choix se fait en fonction de l'indice optique visé.

Lors de l'étape d), la structure et une contre-électrode (CE) sont électriquement reliées à un générateur de tension ou de courant. La structure joue le rôle d'électrode de travail (WE). Par la suite, on le dénommera générateur de tension, mais il pourrait s'agir d'un générateur de courant permettant d'appliquer un courant entre le dispositif et la contre-électrode.

La prise de contact est réalisée sur une couche électriquement conductrice de la structure, de préférence, sur la couche 105 de GaN dopé.

La contre-électrode est en un matériau électriquement conducteur, comme par exemple un métal tel que le platine.

Lors de l'étape d), les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, $HNO_3$, $NaNO_3$ ou $H_2SO_4$ ou un de leurs mélanges.

La tension appliquée peut être comprise entre 1 et 30V par exemple. De préférence, elle est entre 5 et 18V (par exemple entre 5 et 15V), et encore plus préférentiellement entre 6 et 12V, par exemple entre 8 et 10V. La tension est choisie en fonction des taux de dopage des différentes couches et du taux de porosité visé. Elle est appliquée, par exemple, pendant une durée allant de quelques secondes à plusieurs heures. La porosification est complète lorsqu'il n'y a plus de courant à potentiel imposé. A ce moment-là, toute la structure dopée est porosifiée et la réaction électrochimique s'arrête.

L'étape d'anodisation électrochimique peut être réalisée sous lumière ultra-violette (UV).

A l'issue de l'étape de porosification, le taux de porosité de la couche 104 de GaN porosifié est d'au moins 10 %. Il va de préférence de 10 % à 80%, et encore plus préférentiellement de 30% à 70%.

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

La porosification obtenue (taux de porosité et taille des pores) dépend du dopage de la couche et des paramètres du procédé (tension appliquée, durée, nature et concentration de l'électrolyte, post-traitement chimique ou recuit).

L'anodisation de la couche de GaN 104 peut être totale. Selon des variantes de réalisation décrites plus en détail par la suite, l'anodisation peut être partielle. Autrement, une ou plusieurs zones 110 de la couche de GaN fortement dopé ne sont pas porosifiées lors de l'étape d). Chaque zone non porosifiée va de la première face principale à la deuxième face principale pour former un chemin de conduction électrique à travers la couche de GaN. Le chemin de conduction électrique peut avoir la forme d'un canal ou d'un tube par exemple.

Ainsi, la conduction électrique est améliorée et en choisissant la position des zones non porosifiées. Il est de plus possible de jouer sur la relaxation.

Lors de l'étape e), les mésas sont formées. La structuration de l'empilement est, par exemple, réalisée par photolithographie.

Les mésas, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est généralement une gravure plasma (ou gravure sèche). Les reliefs permettent de définir des pixels.

De préférence, les flancs des mésas sont perpendiculaires à cet empilement de couches.

La surface des mésas peut être par exemple circulaire, hexagonale, carrée ou rectangulaire.

La plus grande dimension de la surface des mésas va de 500nm à 500$\mu$m, de préférence de 1 à 10$\mu$m et encore plus préférentiellement de 3 à 5 $\mu$m. Par exemple, la plus grande dimension d'une surface circulaire est le diamètre.

L'épaisseur (ou profondeur) des mésas correspond à la dimension de la mésa perpendiculaire à l'empilement sous-jacent. La profondeur des mésas va de 0,5 à 1$\mu$m, de préférence de 0,3 à 2$\mu$m.

L'espacement entre deux mésas consécutives va de 50nm à 20$\mu$m.

Lors de l'étape f), une deuxième électrode 301 est déposée sur la couche porosifiée 104' (i.e. sur la face supérieure de la couche porosifiée 104'). La deuxième électrode est une couche d'oxyde transparent conducteur. Il peut s'agir d'une couche en oxyde d'indium-étain (ou ITO pour « *indium tin oxide* »), oxyde de zinc dopé à l'alumine (ou AZO pour « *aluminium-doped zinc oxide* »), en oxyde de Zinc Gallium (GZO) ou $SnO_2$. Cette couche recouvre les mésas. La couche d'oxyde transparent conducteur joue le rôle d'électrode supérieure ou de cathode.

Après l'étape f), il est possible de mettre en œuvre une étape g) pour déposer une couche d'encapsulation 302 sur la couche d'oxyde transparent conducteur 301. La couche d'encapsulation 302 est, par exemple, une couche en SiN, SiO₂ ou SiON. Il pourrait également s'agir d'un multi-couche.

Une structuration de la couche d'encapsulation 302 par des micro-lentilles peut aussi être réalisée.

Il est également possible de déposer un anti-réflecteur 303 (i.e. une couche anti-reflet) sur la couche d'encapsulation 302 (étape h)).

Avantageusement, le procédé comprend entre l'étape e) et l'étape f), une étape au cours de laquelle un matériau ou un empilement planarisant 304 est déposé entre les mésas. Le matériau ou l'empilement peut être conducteur ou isolant. De préférence, il inclut du cuivre. Le matériau est, par exemple, déposé par dépôt électrolytique (ou ECD pour « *Electrochemical Deposition* »). Avantageusement, une étape de polissage mécano-chimique (CMP) du matériau déposé 304 est réalisée.

Nous allons maintenant décrire deux variantes de réalisation pour lesquelles le cœur de la couche de GaN fortement dopé des pixels n'est pas porosifiée. Le cœur représente, par exemple, de 5 % à 25 % du volume de la couche.

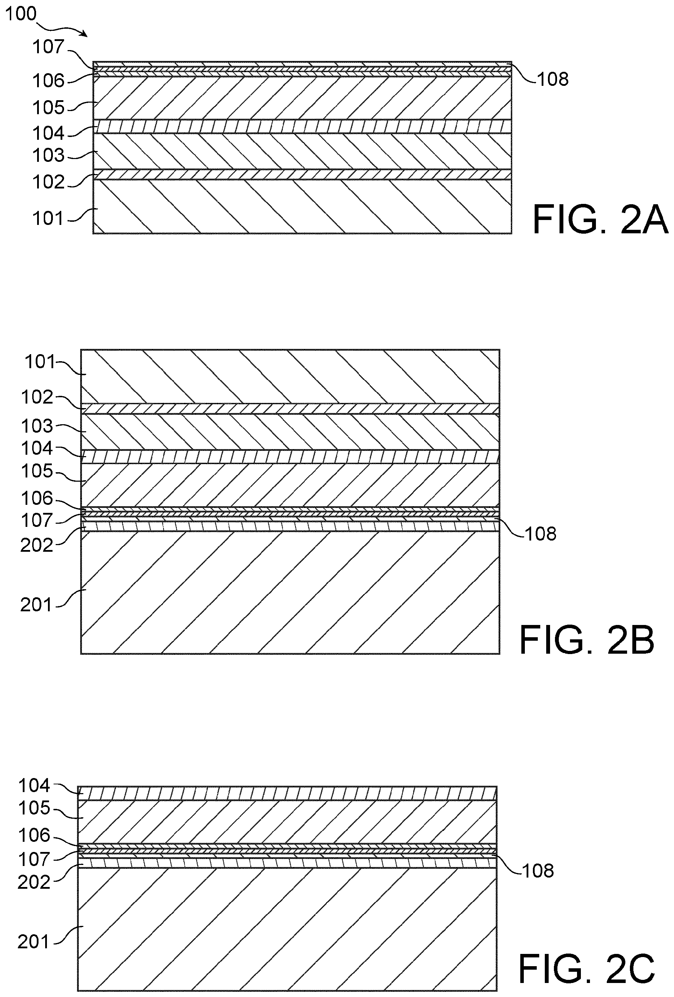

Selon une variante de réalisation avantageuse, représentée sur les figures 2A à 2G, le procédé comprend les étapes suivantes :

   a) fournir un premier empilement 100 comprenant un substrat de base 101, éventuellement une couche tampon 102 en AlGaN, une couche 103 en nid-GaN, une couche 104 de GaN fortement dopé n, une couche 105 de GaN dopé n, des puits quantiques 106 en Gan/InGaN et une couche 107 de GaN dopé p (figure 2A),
   b) reporter le premier empilement 100 sur un deuxième empilement comprenant un substrat support 201 recouvert par une couche métallique 202 (figure 2B),
   c) retirer le substrat de base 101, puis retirer la couche tampon 102 le cas échéant, et la couche 103 en nid-GaN par exemple par amincissement, moyennant quoi on obtient un substrat d'intérêt comprenant un substrat support 201, l'électrode inférieure 202, la couche 107 de GaN dopé p, des puits quantiques 106 en GaN/InGaN, une couche 105 de GaN dopé n, une couche 104 de GaN fortement dopé n (figure 2C),

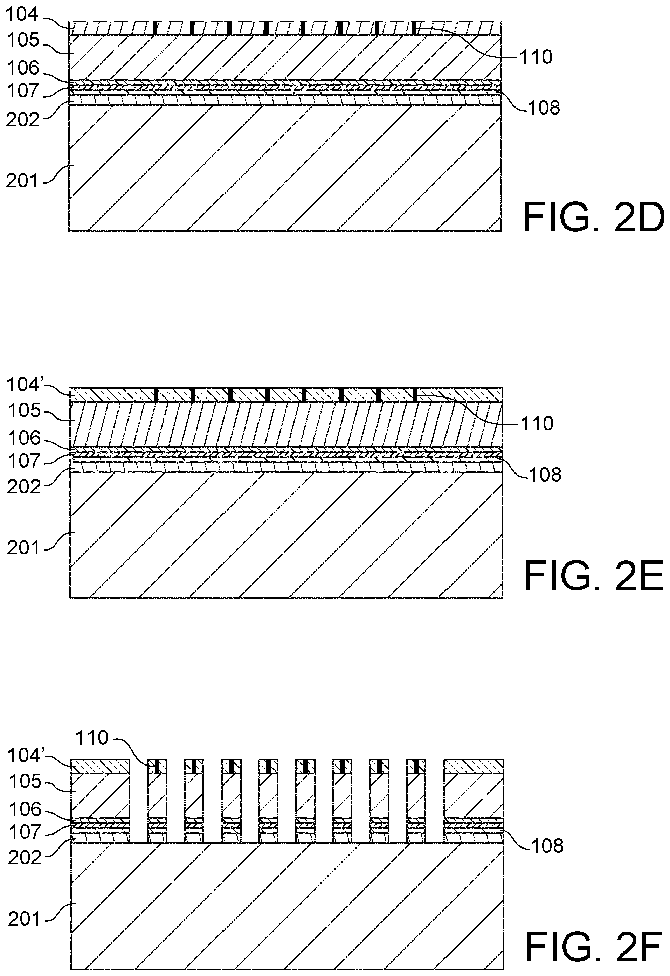

   - modifier localement le taux de dopage de la couche 104 pour former des zones 110 ayant une conductivité électrique inférieure à la première conductivité électrique, par exemple au moyen une implantation ionique, la couche 104 de GaN n++ est ainsi localement 'dé-dopée' et les zones 110 de moindre conductivité ne seront pas porosifiées lors de l'étape d) (figure 2D),

   d) porosifier la couche 104 de GaN fortement dopé n, moyennant quoi on obtient une couche porosifiée 104' comprenant localement des zones 110 peu ou pas porosifiées (figure 2E),
   e) former des mésas dans le substrat d'intérêt, en gravant la deuxième partie de la couche 105 de GaN dopé, les puits quantiques 106, la couche 107 de GaN dopé p, l'électrode inférieure 202 et une partie du substrat support 201, les mésas comprenant ainsi la couche la couche 104' de GaN porosifié ayant localement des zones non porosifiées 110, la couche 105 de GaN dopé, les puits quantiques 106, la couche 107 de GaN dopé p, l'électrode inférieure 202 et une partie du substrat support 201 (figure 2F),

   - de préférence mettre en œuvre une étape de remplissage (avec un matériau 304 ou un empilement de matériau) / planarisation entre les mésas,

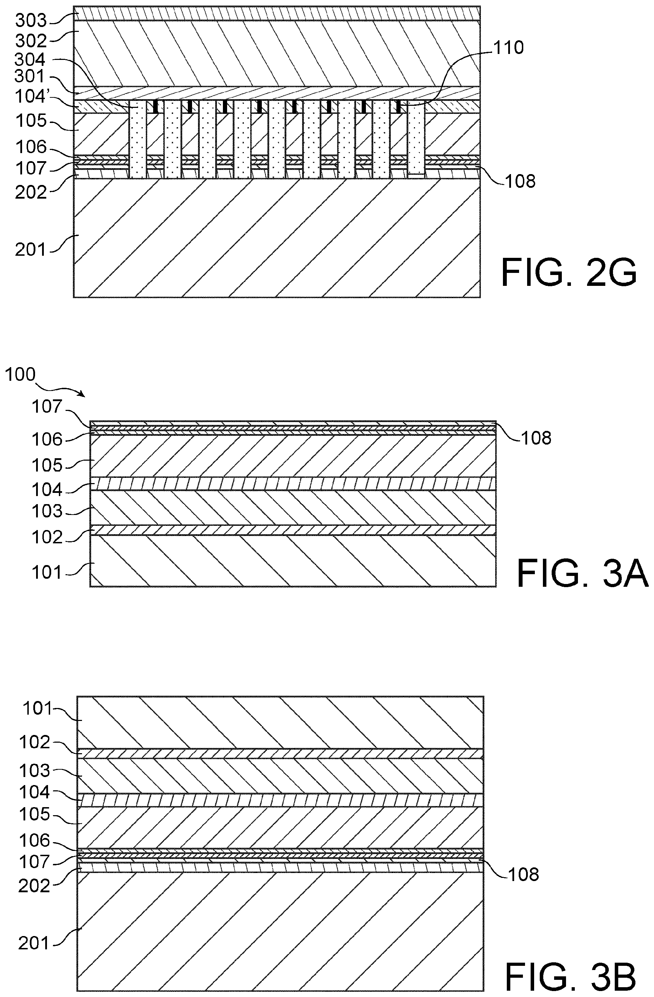

   f) recouvrir les mésas par une électrode supérieure 301 formée d'une couche d'oxyde transparent conducteur (figure 2G),
   g) éventuellement, déposer une couche d'encapsulation 302 sur la couche d'oxyde transparent conducteur et, avantageusement, une couche anti-reflet 303.

La diminution locale du taux de dopage de la couche 104 de GaN fortement dopé est par exemple réalisée en implantant de l'hélium ou de l'hydrogène. L'étape d'implantation ionique permet de réduire la conductivité, désactiver les dopants initialement présents.

Après l'étape de porosification, il est possible de réaliser une étape de recuit thermique pour augmenter la conductivité de la zone 110.

Selon une autre variante de réalisation avantageuse, représentée sur les figures 3A à 3G, le procédé comprend les étapes suivantes :

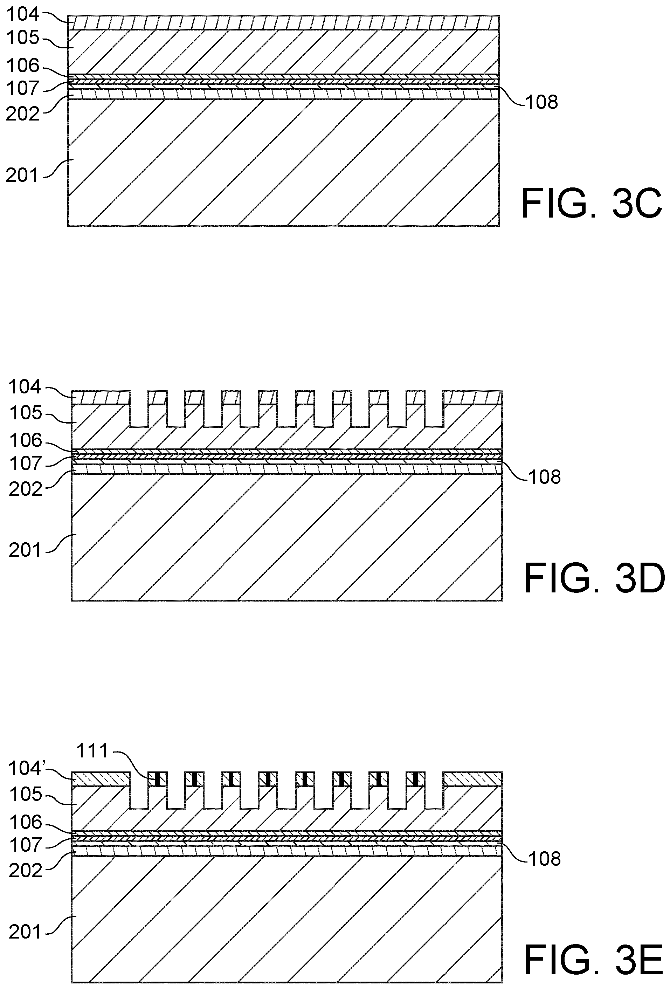

   a) fournir un premier empilement 100 comprenant un substrat de base 101, éventuellement une couche tampon 102 en AlGaN 102, une couche 103 de GaN nid, une couche 104 de GaN fortement dopé n, une couche 105 de GaN dopé n, des puits quantiques 106 en Gan/InGaN et une couche 107 de GaN dopé p (figure 3A),
   b) reporter le premier empilement 100 sur un deuxième empilement comprenant un substrat support 201 et une couche métallique 202 (figure 3B),
   c) retirer le substrat de base 101, puis le cas échéant la couche tampon 102 et la couche 103 de GaN nid, par exemple par amincissement, moyennant quoi on obtient un substrat d'intérêt comprenant un substrat support 201, l'électrode supérieure 202, la couche 107 de GaN dopé p, des puits quantiques 106 en GaN/InGaN, une couche 105 de GaN dopé n, une couche 104 de GaN fortement dopé (figure 3C),

- graver la couche 104 de GaN n++ et une partie de la couche 105 de GaN n pour former des 'pré-pixels' s'arrêtant dans une première partie de la couche 105 de n-GaN, le pré-pixel comprenant la couche 104 de GaN n++ et une partie de la couche 105 de GaN n (figure 3D),

d) porosifier la périphérie de la couche 104 de GaN fortement dopé n (la porosification électro-chimique commençant par le contour des pixels, le processus de porosification est arrêté avant que le cœur ne soit porosifié), la deuxième partie de la couche de n-GaN 105 non gravée permettant de conduire le courant pour l'étape de porosification électro-chimique (figure 3E), moyennant quoi on obtient une couche de GaN partiellement porosifiée 104',

e) former des mésas dans le substrat d'intérêt à partir des pré-pixels, en gravant la deuxième partie de la couche 105 de GaN dopé, les puits quantiques 106, la couche 107 de GaN dopé p, l'électrode inférieure 202 et une partie du substrat support 201, les mésas comprenant ainsi la couche 104' de GaN fortement dopé et partiellement porosifié, la couche 105 de GaN dopé, les puits quantiques 106, la couche 107 de GaN dopé p, la première électrode 108 et une partie du substrat support 201 (figure 3F),

- de préférence mettre en œuvre une étape de remplissage (avec un matériau 304 ou un empilement de matériau) / planarisation entre les mésas,

f) recouvrir les mésas par une électrode supérieure 301 formée d'une couche d'oxyde transparent conducteur,

g) éventuellement, déposer une couche d'encapsulation 302 sur la couche d'oxyde transparent conducteur et, avantageusement, une couche anti-reflet 303.

Nous avons décrit précédemment des variantes de réalisation mettant en œuvre une étape de porosification après report (intégration avec collage monolithique de l'épitaxie).

Nous allons maintenant décrire plus en détail une variante de réalisation où l'étape de porosification est mise en œuvre avant l'étape de report (intégration dite de la puce retournée ou « *flip chip* »).

Selon cette autre variante de réalisation avantageuse, représentée sur les figures 4A à 4J, le procédé peut comprendre les étapes suivantes :

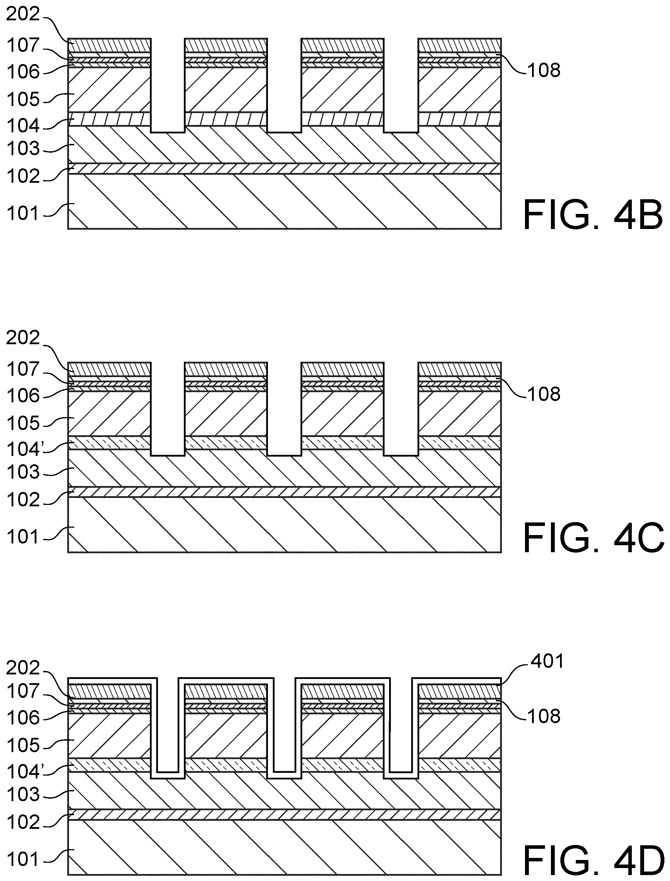

i) fournir un empilement comprenant une couche support 101, une couche 103 de GaN non intentionnellement dopé, une couche 104 de GaN fortement dopé n, une couche 105 de GaN dopé n, des puits quantiques 106 et une couche 107 de GaN dopé p, une première électrode 108 (figure 4A),

iii) former des mésas dans l'empilement, en gravant la première électrode 108, la couche 107 de GaN dopé p, les puits quantiques 106), la couche 105 de GaN dopé n, la couche 104 de GaN fortement dopé n et une partie de la couche 103 de GaN non intentionnellement dopé (figure 4B),

ii) porosifier sélectivement la couche 104 de GaN fortement dopé n, moyennant quoi une couche 104' de GaN porosifié est obtenue (figure 4C),

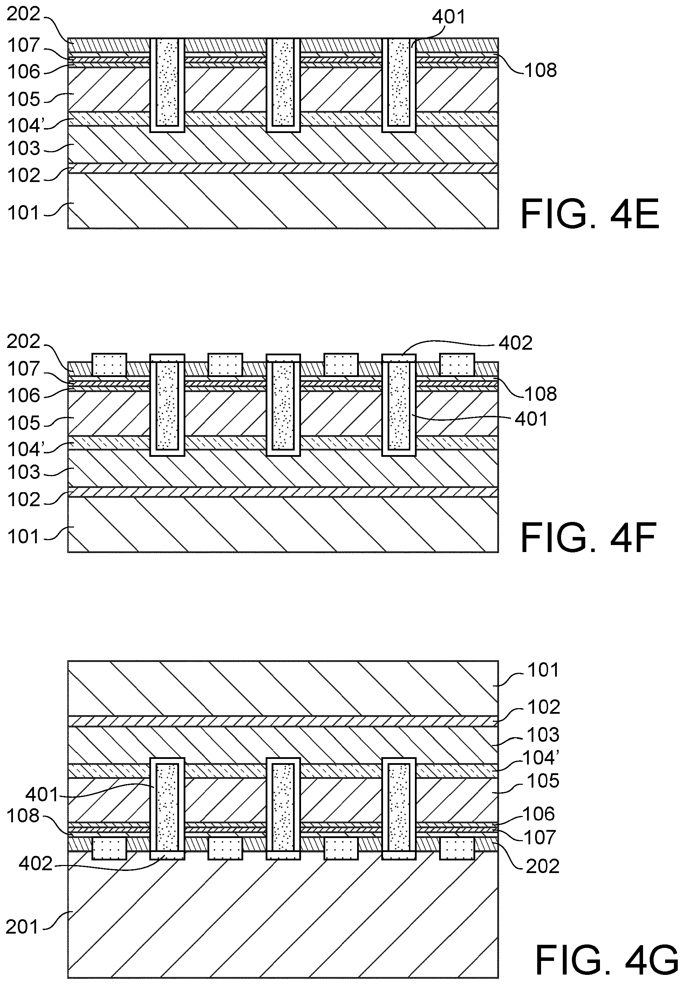

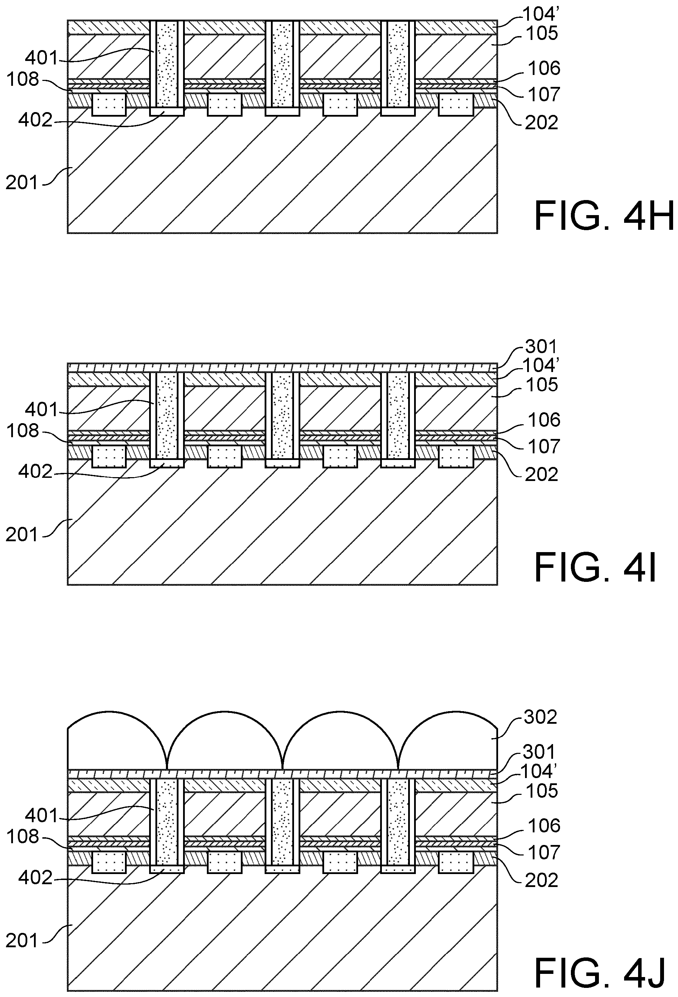

- de préférence déposer une couche diélectrique de passivation 401 (figure 4D),
- graver et planariser la surface supérieure de l'empilement pour mettre en forme la première électrode 108, et de préférence, remplir l'espace inter-mésas avec un élément électriquement conducteur et thermiquement conducteur (figure 4E),
- préparer des plots métalliques 402 pour le collage hybride ou le retournement de puces (« *flip chip* ») (figure 4F),
- reporter l'empilement obtenu sur un substrat support 201, par exemple de type ASIC, comprenant également des plots métalliques (figure 4G),
- retirer la couche support 101, la couche 103 de GaN non intentionnellement dopé, par exemple par amincissement, moyennant quoi on obtient un substrat d'intérêt comprenant le substrat support 201, la première électrode 108, la couche 107 de GaN dopé p, les puits quantiques 106 en GaN/InGaN, la couche 105 de GaN dopé n et la couche 104' de GaN fortement dopé n porosifié (figure 4H),

iv) recouvrir la couche 104' de GaN porosifié par une deuxième électrode 301 formée d'une couche d'oxyde transparent conducteur, de préférence une couche d'oxyde d'indium étain, la deuxième électrode 301 étant en contact direct avec la couche 104' de GaN porosifié (figure 4I),

- déposer une couche d'encapsulation 302 sur la deuxième électrode (figure 4J).

Les caractéristiques des différentes couches, des différents éléments décrits pour cette variante de réalisation où l'étape de porosification est mise en œuvre avant l'étape de report peuvent être identiques aux caractéristiques des différentes couches, des différents éléments décrits pour la variante de réalisation où l'étape de porosification est mise en œuvre après l'étape de report.

La structure micro-LEDs obtenues comprend :

- un substrat d'intérêt dans lequel sont formés des mésas,

le substrat d'intérêt comprenant un substrat support 201, une électrode inférieure 202, une couche 107 de GaN dopé p, des puits quantiques 106 en GaN/InGaN, une couche 105 de GaN dopé n, une couche 104' de GaN complètement ou partiellement porosifié,

les mésas comprenant la couche la couche 104' de GaN porosifié, la couche 105 de GaN dopé, les puits quantiques 106, la couche 107 de GaN dopé p, l'électrode inférieure (ou anode) 202 et une partie du substrat support 201,

- une électrode supérieure 301 (ou cathode) formée d'une couche d'oxyde transparent conducteur, de préférence une couche d'oxyde d'indium étain, recouvrant les mésas,
- éventuellement, par une couche d'encapsulation 302 et une couche anti-reflet 303.

Comme mentionnée, la couche 104' de GaN des mésas peut être complètement porosifiée ou partiellement porosifiée.

Avantageusement, la couche 104' de GaN des mésas comprend une partie centrale non porosifiée 110 et un pourtour porosifié.

La partie centrale peut être faiblement dopée ou fortement dopée.

L'approche est particulièrement intéressante :

- pour des structures dont la couche de GaN est recouverte et en contact avec une électrode transparente puis par une couche d'encapsulation (le GaN ayant un indice optique proche de celui de l'électrode transparente)
- pour des structures où le contact de l'électrode est un contact latéral et où la couche de GaN est recouverte et en contact avec la couche d'encapsulation (le GaN ayant un indice optique proche de celui de la couche d'encapsulation).

Dans tous les cas l'uniformité de l'émission dans l'encapsulation se retrouve dans l'air grâce soit à une structuration qui casse l'effet cavité, soit par l'ajout d'une couche anti-reflet qui permet à la lumière émise dans la couche d'encapsulation, notamment en SiN, de passer directement dans l'air sans de nouveau interagir avec l'empilement de la structure.

**Exemples comparatifs et exemples illustratifs et non limitatifs de différents modes de réalisation :**

Exemple 1 : exemple comparatif avec une structure LED recouverte d'ITO et de SiN :

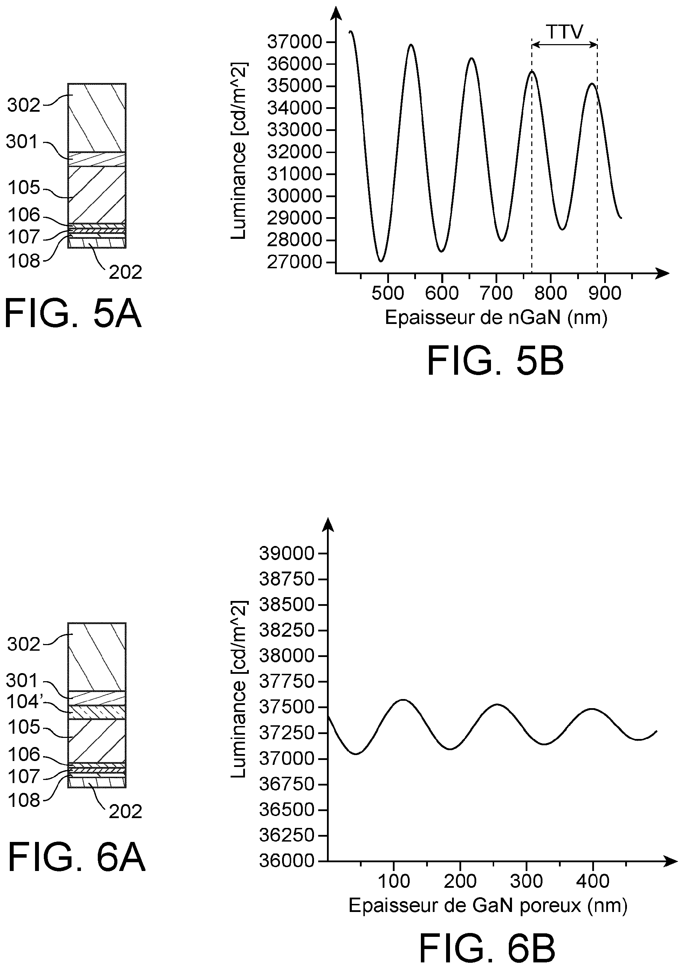

Dans ce premier exemple illustratif, l'empilement LED étudié comprend successivement (figure 5A) : une couche d'aluminium 202, une couche dopée p 107, des puits quantiques 106, une couche 105 de GaN dopé n d'indice optique 2,4, une couche d'oxyde transparent conducteur 301 en ITO d'indice optique 1,91 et une couche d'encapsulation 302 en SiN d'indice optique 1,95.

La simulation de la luminance à 0° (dans l'axe perpendiculaire au plan du de la structure) dans le SiN en fonction de l'épaisseur de n-GaN (figure 5B) montre que la luminance dépend très fortement des variations de l'épaisseur GaN.

Exemple 2 : exemple illustratif avec une structure LED recouverte d'ITO et de SiN :

Dans cet exemple, l'empilement LED étudié comprend successivement (figure 6A) : une couche d'aluminium 202, une couche dopée p 107, des puits quantiques 106, une couche 105 de GaN dopé n d'indice optique 2,4, une couche 104' de GaN poreux d'indice optique 1,9, une couche d'oxyde transparent conducteur 301 en ITO d'indice optique 1,91 et une couche d'encapsulation 302 en SiN d'indice optique 1,95. Par rapport à l'exemple précédent, une couche de GaN poreux a été ajoutée. L'épaisseur de GaN non porosifié est choisie de manière à être à un maximum d'extraction.

La simulation de la luminance à 0° dans le SiN en fonction de l'épaisseur de GaN poreux (figure 6B) confirme que la luminance est beaucoup plus robuste aux variations d'épaisseur de GaN qu'avec la structure de l'exemple 1 comparatif (i.e. quasi indépendante de l'épaisseur de GaN poreux avec une valeur proche du maximum du cas de l'exemple 1).

Exemple 3 : exemple comparatif avec une structure LED recouverte d'ITO, de SiN et de $SiO_2$:

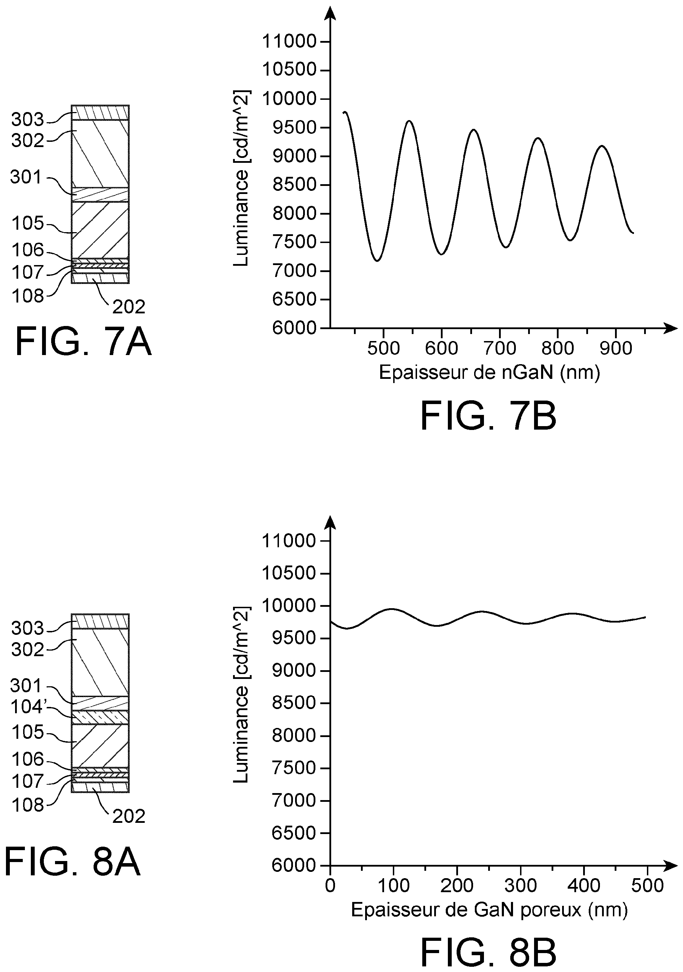

Dans ce premier exemple illustratif, l'empilement LED étudié comprend successivement (figure 7A) : une couche d'aluminium 202, une couche dopée p 107, des puits quantiques 106, une couche de GaN dopé n 105 d'indice optique 2,4, une couche d'oxyde transparent conducteur 301 en ITO d'indice optique 1,91, une couche d'encapsulation 302 en SiN d'indice optique 1,95, une couche anti-reflet 303 en $SiO_2$.

La simulation de la luminance à 0° dans l'air, situé au-dessus de la couche 303, en fonction de l'épaisseur de n-GaN (figure 7B) montre que la luminance dépend très fortement des variations de l'épaisseur GaN.

Exemple 4 : exemple illustratif avec une structure LED recouverte d'ITO, de SiN et de $SiO_2$:

Dans cet exemple, l'empilement LED étudié comprend successivement (figure 8A) : une couche d'aluminium 202, une couche dopée p 107, des puits quantiques 106, une couche 105 de GaN dopé n d'indice optique 2,4, une couche 104' de GaN poreux d'indice optique 1,9, une couche d'oxyde transparent conducteur 301 en ITO d'indice optique 1,91, une couche d'encapsulation 302 en SiN d'indice optique 1,95, une couche anti-reflet 303 en SiO$_2$.

L'épaisseur de GaN non porosifié est choisie de manière à être à un maximum d'extraction.

La simulation de la luminance à 0° dans l'air, situé au-dessus de la couche 303, en fonction de l'épaisseur de GaN poreux (figure 8B) confirme que la luminance est beaucoup plus robuste aux variations d'épaisseur de GaN qu'avec la structure de l'exemple 3 comparatif, c'est-à-dire quasi-indépendante de l'épaisseur de GaN poreux.

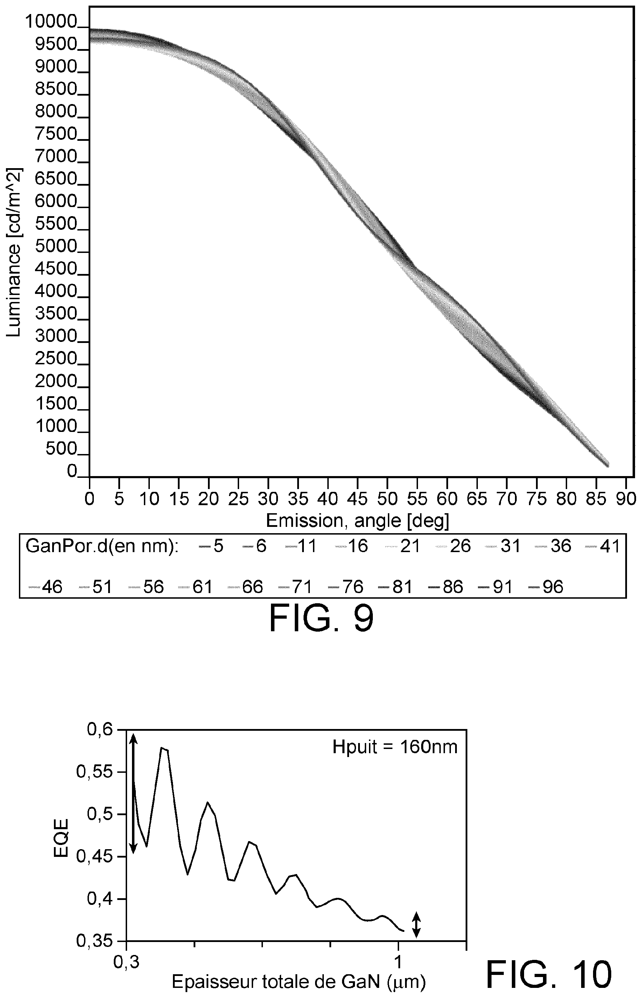

De plus, la simulation de la luminance dans l'air en fonction de l'angle d'observation pour différentes épaisseurs de GaN poreux (figure 9) montre que la luminance dans l'air est peu impactée par l'épaisseur de GaN poreux même aux angles différents de 0°.

La simulation 2D du rendement quantique externe ou EQE (dans l'air) d'une micro-LED ayant des mésas de taille d'environ 1 μm en fonction de l'épaisseur de GaN a également été étudiée (figure 10). La microLED n'est pas recouverte par une couche d'encapsulation. Il est à noter que cette simulation représente l'EQE globale (entre 0 et 90°).

Il est intéressant de noter que plus les épaisseurs de GaN sont faibles, plus les EQE sont élevés et plus les oscillations en fonction de l'épaisseur de GaN sont importantes. Il est probable que les effets d'oscillations seront d'autant plus forts que l'espace angulaire sera réduit, par exemple si l'émission considérée est entre 0 et 18.5° dans l'axe perpendiculaire au plan de la structure.

**Revendications**

1. Procédé de fabrication de micro-LED comprenant au moins les étapes suivantes :

   i) fournir un empilement comprenant au moins une couche de GaN fortement dopé n (104), une couche de GaN dopé n (105), des puits quantiques (106) et une couche de GaN dopé p (107) et une première électrode (108),
   ii) porosifier la couche de GaN fortement dopé n (104), moyennant quoi une couche de GaN porosifié (104') est obtenue,
   iii) former des mésas dans l'empilement,
   iv) recouvrir la couche de GaN porosifié (104') par une deuxième électrode (301) formée d'une couche d'oxyde transparent conducteur, la deuxième électrode (301) étant en contact direct avec la couche de GaN porosifié (104'), puis, de préférence, recouvrir la deuxième électrode (301) par une couche d'encapsulation (302),

   ou

   déposer une deuxième électrode (301) sur une face latérale de la couche de GaN porosifié (104') ou sur une face latérale de la couche de GaN dopé n (105) et recouvrir la couche de GaN porosifié (104') par une couche d'encapsulation (302), la couche d'encapsulation (302) étant en contact direct avec la couche de GaN porosifié (104'),

   les étapes ii) et iii) pouvant être réalisées dans l'ordre ii) et iii) ou dans l'ordre iii) et ii),
   l'étape ii) étant réalisée de manière à ce que l'indice optique de la couche de GaN porosifié (104') ne varie pas de plus de 10% par rapport à l'indice optique de la deuxième électrode (301) et/ou par rapport à l'indice optique de la couche d'encapsulation (302).

2. Procédé selon la revendication 1, dans lequel la couche d'oxyde transparent conducteur est une couche d'oxyde d'indium étain et/ou en ce que la couche d'encapsulation (302) est en SiN, SiO$_2$ ou SiON.

3. Procédé selon l'une quelconque des revendications 1 à 2, dans lequel la concentration volumique de pores dans la couche de GaN porosifié (104') est déterminée à partir de la formule suivante :

$$n_{eff} = \sqrt{(1-p).n_{GaN}^2 + p.n_{air}^2}$$

avec p la concentration volumique de pores, $n_{GaN}$ l'indice optique du GaN et $n_{air}$ l'indice optique de l'air.

4. Procédé selon l'une quelconque des revendications 1 à 3, dans lequel l'étape i) est réalisée selon les étapes a) à c) suivantes :

   a) fournir un empilement initial (100) comprenant une couche support (101), éventuellement une couche tampon en (Al,Ga)N (102), une couche de GaN non intentionnellement dopé (103), la couche de GaN fortement dopé n (104), la couche de GaN dopé n (105), les puits quantiques (106), la couche de GaN dopé p (107) et la première électrode (108),
   b) reporter l'empilement initial (100) sur un substrat support (201) recouvert par une couche métallique (202),
   c) retirer la couche support (101), le cas échéant la couche tampon en (Al,Ga)N (102), la couche de GaN non intentionnellement dopé (103), par exemple par amincissement, moyennant quoi on obtient un substrat d'intérêt comprenant le substrat support (201), la première électrode (108), la couche de GaN dopé p (107), les puits quantiques GaN/InGaN (106), la couche de GaN dopé n (105) et la couche de GaN fortement dopé n (104).

**5.** Procédé selon la revendication 4, dans lequel, avant l'étape ii), le procédé comprend une étape au cours de laquelle le taux de dopage de la couche de GaN fortement dopé n (104) est diminué localement, par exemple par implantation d'ions hélium ou hydrogène, de manière à avoir une première partie de la couche de GaN fortement dopé n (104) ayant une première conductivité et une deuxième partie (110) ayant une deuxième conductivité, la première conductivité électrique étant supérieure d'au moins un facteur dix à la deuxième conductivité électrique, moyennant quoi :

- la deuxième partie (110) n'est pas porosifiée lors de l'étape ii),
- la couche de GaN porosifié (104') des mésas obtenues à l'étape iii) comprend une partie non porosifiée (110) et une partie porosifiée, la partie non porosifiée (110) étant de préférence au centre de la partie porosifiée.

**6.** Procédé selon la revendication 4, dans lequel :

- le procédé comprend une étape additionnelle entre l'étape i) et l'étape ii) au cours de laquelle la couche de GaN fortement dopé n (104) et une partie de la couche de GaN dopé n (105) sont gravées pour former une pré-structure de mésas,
- lors de l'étape ii), une partie centrale (111) de la couche de GaN fortement dopé n (104) n'est pas porosifiée, par exemple en arrêtant l'étape de porosification avant la porosification totale de la couche de GaN fortement dopé (104), moyennant quoi la couche de GaN (104') des mésas obtenues à l'étape iii) comprend la partie centrale non porosifiée (111) et un pourtour porosifié,
- l'étape iii) est réalisée en gravant l'autre partie de la couche de GaN dopé n (105), les puits quantiques (106), la couche de GaN dopé p (107), la première électrode (108) et une partie du substrat support (201).

**7.** Procédé selon l'une quelconque des revendications 1 à 3, dans lequel le procédé comprend les étapes successives suivantes :

i) fournir un empilement comprenant une couche support (101), une couche de GaN non intentionnellement dopé (103), la couche de GaN fortement dopé n (104), la couche de GaN dopé n (105), les puits quantiques (106) et la couche de GaN dopé p (107) et la première électrode (108),
iii) former des mésas dans l'empilement, en gravant la première électrode (108), la couche de GaN dopé p (107), les puits quantiques (106), la couche de GaN dopé n (105), la couche de GaN fortement dopé n (104) et une partie de la couche de GaN non intentionnellement dopé (103),
- mettre en œuvre l'étape ii), moyennant quoi une couche de GaN porosifié (104') est obtenue,
- reporter l'empilement obtenu sur un substrat support (201) recouvert par une couche métallique (202),
- retirer la couche support (101), la couche de GaN non intentionnellement dopé (103), par exemple par amincissement, moyennant quoi on obtient un substrat d'intérêt comprenant le substrat support (201), la première électrode (108), la couche de GaN dopé p (107), les puits quantiques GaN/InGaN (106), la couche de GaN dopé n (105) et la couche de GaN fortement dopé n (104),
- mettre en œuvre l'étape iv).

**8.** Structure de micro-LEDs comprenant un empilement, l'empilement comprenant au moins une couche de GaN fortement dopé n porosifié (104'), une couche de GaN dopé n (105), des puits quantiques (106) et une couche de GaN dopé p (107), une première électrode (108), des mésas étant formées dans l'empilement,

la couche de GaN porosifié (104') étant recouverte et en contact direct avec une deuxième électrode (301) formée d'une couche d'oxyde transparent conducteur, la deuxième électrode (301) étant de préférence recouverte par une couche d'encapsulation (302),
ou
une deuxième électrode (301) étant disposée sur une face latérale de la couche de GaN porosifié (104') ou sur une face latérale de la couche de GaN dopé n (105), la couche de GaN porosifié (104') étant recouverte et en contact direct avec une couche d'encapsulation (302), dans tous les cas, l'indice optique de la couche de GaN porosifié (104') ne variant pas de plus de 10% par rapport à l'indice optique de la deuxième électrode (301) et/ou par rapport à l'indice optique de la couche d'encapsulation (302).

**9.** Structure selon la revendication 8, dans laquelle la couche de GaN porosifié (104') des mésas comprend une partie centrale non porosifiée (110, 111) et un pourtour porosifié.

**10.** Structure selon la revendication 9, dans laquelle la partie centrale (110) est faiblement dopée.

**11.** Structure selon la revendication 9, dans laquelle la partie centrale (111) est fortement dopée.

**12.** Structure selon l'une quelconque des revendications 8 à 11, dans laquelle la couche de GaN porosifié (104') a une épaisseur comprise entre 100 et 500nm, de préférence entre 300 et 500 nm.

## Patentansprüche

**1.** Verfahren zur Herstellung von Mikro-LEDs, das mindestens folgende Schritte umfasst:

i) Bereitstellen eines Stapels, der mindestens eine n-dotierte GaN-Schicht (104), eine n-dotierte GaN-Schicht (105), Quanten-Wells (106) und eine p-dotierte GaN-Schicht (107) und eine erste Elektrode (108) umfasst,

ii) Porosifizieren der stark n-dotierten GaN-Schicht (104), wodurch eine porosifizierte GaN-Schicht (104') erhalten wird,

iii) Bilden von Mesas im Stapel,

iv) Bedecken der porosifizierten GaN-Schicht (104') mit einer zweiten Elektrode (301), die aus einer Schicht aus leitfähigem, transparentem Oxid gebildet ist, wobei die zweite Elektrode (301) in direktem Kontakt mit der porosifizierten GaN-Schicht (104') steht, anschließend, Bedecken, vorzugsweise, der zweiten Elektrode (301) mit einer Kapselschicht (302),

oder

Ablegen einer zweiten Elektrode (301) auf eine Seitenfläche der porosifizierten GaN-Schicht (104') oder auf eine Seitenfläche der n-dotierten GaN-Schicht (105) und die porosifizierten GaN-Schicht (104') mit einer Kapselschicht (302) bedecken, wobei die Kapselschicht (302) in direktem Kontakt mit der porosifizierten GaN-Schicht (104') steht,

wobei die Schritte ii) und iii) in der Reihenfolge ii) und iii) oder in der Reihenfolge iii) und ii) durchgeführt werden können,

wobei Schritt ii) so ausgeführt ist, dass der optische Index der porosifizierten GaN-Schicht (104') nicht um mehr als 10 % im Verhältnis zum optischen Index der zweiten Elektrode (301) und/oder im Verhältnis zum optischen Index der Kapselschicht (302) variiert.

**2.** Verfahren nach Anspruch 1, wobei die leitfähige transparente Oxidschicht eine Zinn-Indiumoxidschicht ist und/oder die Kapselschicht (302) aus SiN, $SiO_2$ oder SiON besteht.

**3.** Verfahren nach einem der Ansprüche 1 bis 2, wobei die Volumenkonzentration von Poren in der porosifizierten GaN-Schicht (104') nach folgender Formel bestimmt wird:

$$n_{eff} = \sqrt{(1-p).n_{GaN}^2 + p.n_{luft}^2}$$

wobei p die Volumenkonzentration von Poren, $n_{Gan}$ der optische Index von GaN und $n_{luft}$ der optische Index von Luft ist.

**4.** Verfahren nach einem der Ansprüche 1 bis 3, **dadurch gekennzeichnet, dass** der Schritt i) nach folgenden aufeinanderfolgenden Schritten a) bis c) durchgeführt wird:

a) Bereitstellen eines Anfangsstapels (100) umfassend eine Trägerschicht (101), gegebenenfalls eine Pufferschicht aus (Al,Ga)N (102), eine nicht absichtlich dotierte GaN-Schicht (103), die stark n-dotierte GaN-Schicht (104), die n-dotierte GaN-Schicht (105), die Quanten-Wells (106), die p-dotierte GaN-Schicht (107) und die erste Elektrode (108),

b) Übertragen des ursprünglichen Stapels (100) auf ein Trägersubstrat (201), das mit einer Metallschicht (202) bedeckt ist,

c) Entfernen der Trägerschicht (101), gegebenenfalls der (Al,Ga)N-Pufferschicht (102), der nicht absichtlich dotierten GaN-Schicht (103), beispielsweise durch Ausdünnen, wodurch ein zu untersuchendes Substrat erhalten wird, das das Trägersubstrat (201), die erste Elektrode (108), die p-dotierte GaN-Schicht (107), die GaN/InGaN-Quanten-Wells (106), die n-dotierte GaN-Schicht (105) und die stark n-dotierte GaN-Schicht (104) umfasst.

**5.** Verfahren nach Anspruch 4, wobei das Verfahren vor Schritt ii) einen Schritt umfasst, bei dem die Dotierungsrate der stark n-dotierten GaN-Schicht (104) lokal verringert wird, beispielsweise durch Implantation von Helium- oder Wasserstoffionen, so dass ein erster Teil der stark n-dotierten GaN-Schicht (104) eine erste Leitfähigkeit und ein zweiter Teil (110) eine zweite Leitfähigkeit aufweist, wobei die erste elektrische Leitfähigkeit um mindestens einen Faktor zehn höher ist als die zweite elektrische Leitfähigkeit, wodurch:

- der zweite Teil (110) in Schritt ii) nicht porosifiziert ist,

- die porosifizierte GaN-Schicht (104') der in Schritt iii) erhaltenen Mesas einen nicht porosifizierten Teil (110) und einen porosifizierten Teil umfasst, wobei der nicht porosifizierte Teil (110) vorzugsweise in der Mitte des porosifizierten Teils liegt.

**6.** Verfahren nach Anspruch 4, wobei:

- das Verfahren einen zusätzlichen Schritt zwischen Schritt i) und Schritt ii) umfasst, bei dem die stark n-dotierte GaN-Schicht (104) und ein Teil der n-dotierten GaN-Schicht (105) geätzt werden, um eine Mesas-Vorstruktur zu bilden,
- bei Schritt ii) ein Mittelteil (111) der stark n-dotierten GaN-Schicht (104) nicht porosifiziert wird, indem beispielsweise der Porosifizierungsschritt vor der vollständigen Porosifizierung der stark dotierten GaN-Schicht (104) gestoppt wird, wodurch die GaN-Schicht (104') der in Schritt iii) erhaltenen Mesas den nicht porosifizierten Mittelteil (111) und einen porosifizierten Umfang umfasst,
- Schritt iii) durch Ätzen des anderen Teils der n-dotierten GaN-Schicht (105), der Quanten-Wells (106), der p-dotierten GaN-Schicht (107), der ersten Elektrode (108) und eines Teils des Trägersubstrats (201) erfolgt.

7. Verfahren nach einem der Ansprüche 1 bis 3, wobei das Verfahren folgende aufeinanderfolgende Schritte umfasst:

   i) Bereitstellen eines Stapels, der eine Trägerschicht (101), eine nicht absichtlich dotierte GaN-Schicht (103), die stark n-dotierte GaN-Schicht (104), die n-dotierte GaN-Schicht (105), die Quanten-Wells (106) und die p-dotierte GaN-Schicht (107) und die erste Elektrode (108) umfasst,
   iii) Bilden von Mesas im Stapel, durch Ätzen der ersten Elektrode (108), der p-dotierten GaN-Schicht (107), der Quanten-Wells (106), der n-dotierten GaN-Schicht (105), der stark n-dotierten GaN-Schicht (104) und eines Teils der nicht absichtlich dotierten GaN-Schicht (103),
   - Durchführen des Schritts ii), wobei eine porosifizierte GaN-Schicht (104') erhalten wird,
   - Übertragen des erhaltenen Stapels auf ein Trägersubstrat (201), das mit einer Metallschicht (202) bedeckt ist,
   - Entfernen der Trägerschicht (101), der nicht absichtlich dotierten GaN-Schicht (103), beispielsweise durch Ausdünnen, wodurch ein Substrat von Interesse erhalten wird, das das Trägersubstrat (201), die erste Elektrode (108), die p-dotierte GaN-Schicht (107), die GaN/InGaN-Quanten-Wells (106), die n-dotierte GaN-Schicht (105) und die stark n-dotierte GaN-Schicht (104) umfasst,
   - Durchführen von Schritt iv).

8. Struktur von Mikro-LEDs, umfassend einen Stapel, wobei der Stapel mindestens eine stark n-dotierte, porosifizierte GaN-Schicht (104'), eine n-dotierte GaN-Schicht (105), Quanten-Wells (106) und eine p-dotierte GaN-Schicht (107) umfasst, wobei eine erste Elektrode (108) ist, wobei im Stapel Mesas gebildet sind,

   wobei die porosifizierte GaN-Schicht (104') bedeckt ist und in direktem Kontakt mit einer zweiten Elektrode (301) steht, die aus einer Schicht aus leitfähigem, transparentem Oxid gebildet ist, wobei die zweite Elektrode (301) vorzugsweise von einer Kapselschicht (302) bedeckt ist, oder
   wobei eine zweite Elektrode (301) an einer Seitenfläche der porosifizierten GaN-Schicht (104') oder an einer Seitenfläche der n-dotierten GaN-Schicht (105) angeordnet ist, wobei die porosifizierte GaN-Schicht (104') bedeckt ist und in direktem Kontakt mit einer Kapselschicht (302) steht,
   wobei, in jedem Fall, der optische Index der porosifizierten GaN-Schicht (104') nicht mehr als 10 % im Verhältnis zum optischen Index der zweiten Elektrode (301) und/oder im Verhältnis zum optischen Index der Kapselschicht (302) variiert.

9. Struktur nach Anspruch 8, wobei die porosifizierte GaN-Schicht (104') der Mesas einen nicht porosifizierten Mittelteil (110, 111) und einen porosifizierten Umfang umfasst.

10. Struktur nach Anspruch 9, wobei der Mittelteil (110) schwach dotiert ist.

11. Struktur nach Anspruch 9, wobei der Mittelteil (111) stark dotiert ist.

12. Struktur nach einem der Ansprüche 8 bis 11, wobei die porosifizierte GaN-Schicht (104') eine Dicke zwischen 100 und 500 nm, vorzugsweise zwischen 300 und 500 nm aufweist.

**Claims**

1. A method for manufacturing micro-LEDs comprising at least the following steps:

   i) providing a stack comprising at least one heavily n-doped GaN layer (104), one n-doped GaN layer (105), quantum wells (106) and one p-doped GaN layer (107) and a first electrode (108),
   ii) porosifying the heavily n-doped GaN layer (104), whereby a porosified GaN layer (104') is obtained,
   iii) forming mesas in the stack,
   iv) covering the porosified GaN layer (104') with a second electrode (301) formed of a transparent conducting oxide layer, the second electrode (301) being in direct contact with the porosified GaN layer (104'), then, preferably, covering the second electrode (301) with an encapsulation layer (302),

or

depositing a second electrode (301) on a lateral face of the porosified GaN layer (104') or on a lateral face of the n-doped GaN layer (105) and covering the porosified GaN layer (104') with an encapsulation layer (302), the encapsulation layer (302) being in direct contact with the porosified GaN layer (104'),

where steps ii) and iii) can be performed in the order ii) and iii) or in the order iii) and ii),

step ii) being carried out such that the optical index of the porosified GaN layer (104') does not vary by more than 10% with respect to the optical index of the second electrode (301) and/or with respect to the optical index of the encapsulation layer (302).

2. The method according to claim 1, wherein the transparent conducting oxide layer is an indium tin oxide layer and/or in that the encapsulation layer (302) is made of SiN, $SiO_2$ or SiON.

3. The method according to any one of claims 1 to 2, wherein the pore volume concentration in the porosified GaN layer (104') is determined using the following formula:

$$n_{eff} = \sqrt{(1 - p).n_{GaN}^2 + p.n_{air}^2}$$

where p is the pore volume concentration, $n_{GaN}$ is the optical index of GaN and $n_{air}$ is the optical index of air.

4. The method according to any one of claims 1 to 3, wherein step i) is carried out according to the following steps a) to c):

a) providing an initial stack (100) comprising a support layer (101), optionally a buffer layer made of (Al,Ga)N (102), an unintentionally doped GaN layer (103), the heavily n-doped GaN layer (104), the n-doped GaN layer (105), the quantum wells (106), the p-doped GaN layer (107) and the first electrode (108),

b) transferring the initial stack (100) onto a support substrate (201) covered by a metal layer (202),

c) removing the support layer (101), where applicable the buffer layer made of (Al,Ga)N (102), the unintentionally doped GaN layer (103), for example by thinning, whereby a substrate of interest comprising the support substrate (201), the first electrode (108), the p-doped GaN layer (107), the GaN/InGaN quantum wells (106), the n-doped GaN layer (105) and the heavily n-doped GaN layer (104) is obtained.

5. The method according to claim 4, wherein, prior to step ii), the method comprises a step during which the doping ratio of the heavily n-doped GaN layer (104) is decreased locally, for example by helium or hydrogen ion implantation, so as to have a first part of the heavily n-doped GaN layer (104) having a first conductivity and a second part (110) having a second conductivity, the first electrical conductivity being greater by at least a factor of ten than the second electrical conductivity, whereby:

- the second part (110) is not porosified during step ii),
- the porosified GaN layer (104') of the mesas obtained in step iii) comprises a non-porosified part (110) and a porosified part, the non-porosified part (110) being preferably at the centre of the porosified part.

6. The method according to claim 4, wherein

- the method comprises an additional step between step i) and step ii) during which the heavily n-doped GaN layer (104) and a part of the n-doped GaN layer (105) are etched to form a mesa pre-structure,
- during step ii), a central part (111) of the heavily n-doped GaN layer (104) is not porosified, for example by stopping the porosification step before the total porosification of the heavily doped GaN layer (104), whereby the GaN layer (104') of the mesas obtained in step iii) comprises the non-porosified central part (111) and a porosified perimeter,
- step iii) is carried out by etching the other part of the n-doped GaN layer (105), the quantum wells (106), the p-doped GaN layer (107), the first electrode (108) and a part of the support substrate (201).

7. The method according to any one of claims 1 to 3, wherein the method comprises the following successive steps:

i) providing a stack comprising a support layer (101), an unintentionally doped GaN layer (103), the heavily n-doped GaN layer (104), the n-doped GaN layer (105), the quantum wells (106) and the p-doped GaN layer (107) and the first electrode (108),

iii) forming mesas in the stack, by etching the first electrode (108), the p-doped GaN layer (107), the quantum wells (106), the n-doped GaN layer (105), the heavily n-doped GaN layer (104) and a part of the unintentionally doped GaN layer (103),
- implementing step ii), whereby a porosified GaN layer (104') is obtained,
- transferring the stack obtained onto a support substrate (201) covered by a metal layer (202),
- removing the support layer (101), the unintentionally doped GaN layer (103), for example by thinning, whereby a substrate of interest comprising the support substrate (201), the first electrode (108), the p-doped GaN layer (107), the GaN/InGaN quantum wells (106), the n-doped GaN layer (105) and the heavily n-doped GaN layer (104) is obtained,
- implementing step iv).

8. A micro-LED structure comprising a stack, the stack comprising at least one layer of porosified heavily n-doped GaN (104'), an n-doped GaN layer (105), quantum wells (106) and a p-doped GaN layer (107), a first electrode (108), mesas being formed in the stack,

> the porosified GaN layer (104') being covered and in direct contact with a second electrode (301) formed of a transparent conducting oxide layer, the second electrode (301) preferably being covered by an encapsulation layer (302), or
> a second electrode (301) being disposed on a lateral face of the porosified GaN layer (104') or on a lateral face of the n-doped GaN layer (105), the porosified GaN layer (104') being covered and in direct contact with an encapsulation layer (302),
> in any case, the optical index of the porosified GaN layer (104') does not vary by more than 10% with respect to the optical index of the second electrode (301) and/or with respect to the optical index of the encapsulation layer (302).

9. The structure according to claim 8, wherein the porosified GaN layer (104') of the mesas comprises a non-porosified central part (110, 111) and a porosified perimeter.

10. The structure according to claim 9, wherein the central part (110) is lightly doped.

11. The structure according to claim 9, wherein the central part (111) is heavily doped.

12. The structure according to any one of claims 8 to 11, wherein the porosified GaN layer (104') has a thickness between 100 and 500nm, preferably between 300 and 500 nm.

FIG. 1A

FIG. 1B

FIG. 1C

FIG. 1D

FIG. 1E

FIG. 1F

100

107
106
105
104
103
102
101

108

FIG. 2A

101
102
103
104
105
106
107
202

201

108

FIG. 2B

104
105
106
107
202

201

108

FIG. 2C

104
105
106
107
202

110

108

201

# FIG. 2D

104'
105
106
107
202

110

108

201

# FIG. 2E

110

104'
105
106
107
202

108

201

# FIG. 2F

303
302
304
301
104'
105
106
107
202
201

110

108

# FIG. 2G

100
107
106
105
104
103
102
101

108

# FIG. 3A

101
102
103
104
105
106
107
202
201

108

# FIG. 3B

104
105
106
107
202
201
108

FIG. 3C

104
105
106
107
202
201
108

FIG. 3D

111
104'
105
106
107
202
201
108

FIG. 3E

111

104'
105

106
107
202

201

108

FIG. 3F

303
302
304
301
104'

105

106
107
202

201

111

108

FIG. 3G

202
107
106
105
104
103
102
101

108

FIG. 4A

202
107
106
105
104
103
102
101
108

FIG. 4B

202
107
106
105
104'
103
102
101
108

FIG. 4C

401
202
107
106
105
104'
103
102
101
108

FIG. 4D

202
107
106
105
104'
103
102
101
401
108

**FIG. 4E**

202
107
106
105
104'
103
102
101
402
108
401

**FIG. 4F**

101
102
103
104'
105
106
107
202
401
108
402
201

**FIG. 4G**

FIG. 4H

FIG. 4I

FIG. 4J

FIG. 5A

FIG. 5B

FIG. 6A

FIG. 6B

FIG. 7A

FIG. 7B

Luminance [cd/m^2]

Epaisseur de nGaN (nm)

FIG. 8A

FIG. 8B

Luminance [cd/m^2]

Epaisseur de GaN poreux (nm)

GanPor.d(en nm):  —5  —6  —11  —16  —21  —26  —31  —36  —41
—46  —51  —56  —61  —66  —71  —76  —81  —86  —91  —96

FIG. 9

Hpuit = 160nm

FIG. 10

## RÉFÉRENCES CITÉES DANS LA DESCRIPTION

**Documents brevets cités dans la description**

- US 20200251460 A1
- WO 2021233917 A1
- GB 2592017 A


**Littérature non-brevet citée dans la description**

- **LIN et al.** InGaN resonant microcavity with n+-porous-GaN/p+- GaN tunneling junction. *IEEE Elec. Dev. Lett*, 2021, vol. 42 (11)
- **MISHKAT-UI-MASABIH et al.** Electrically injected nonpolar GaN-based VCSELs with lattice-matched nanoporous distributed Bragg Reflector mirrors. *Appl. Phys. Express*, 2019, vol. 12 (036504)